Europäisches Patentamt

European Patent Office

Office européen des brevets

(19)

(11) Publication number: **0 143 632 B1**

# EUROPEAN PATENT SPECIFICATION

(12)

(45) Date of publication of patent specification: **29.01.92**  (51) Int. Cl.⁵: **H03H 17/06**, G06F 15/336

(21) Application number: **84308175.3**

(22) Date of filing: **26.11.84**

(54) **A convolution arithmetic circuit.**

(30) Priority: **26.11.83 JP 221409/83**
**13.02.84 JP 22756/84**

(43) Date of publication of application:
**05.06.85 Bulletin 85/23**

(45) Publication of the grant of the patent:
**29.01.92 Bulletin 92/05**

(84) Designated Contracting States:
**DE FR GB NL**

(56) References cited:

ELEKTRONIK, vol. 29, no. 20, 2. October 1980,
pages 61-66, Munich, DE; L. KLAAS:
"Digitales Transversalfilter als universeller
Signalprozessor"

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Konishi, Kazuo c/o Patent Division**
**Toshiba Corporation Principal Office**
**1-1, Shibaura 1-chome Minato-ku Tokyo(JP)**
Inventor: **Nishikawa, Meisei c/o Patent Division**
**Toshiba Corporation Principal Office**
**1-1, Shibaura 1-chome Minato-ku Tokyo(JP)**

(74) Representative: **Newstead, Michael John et al**
**Haseltine Lake & Co. 28 Southampton Build-**
**ings Chancery Lane**
**London, WC2A 1AT(GB)**

## Description

This invention relates to a convolution arithmetic circuit for application to a digital signal processing system such as, for example, a digital filter.

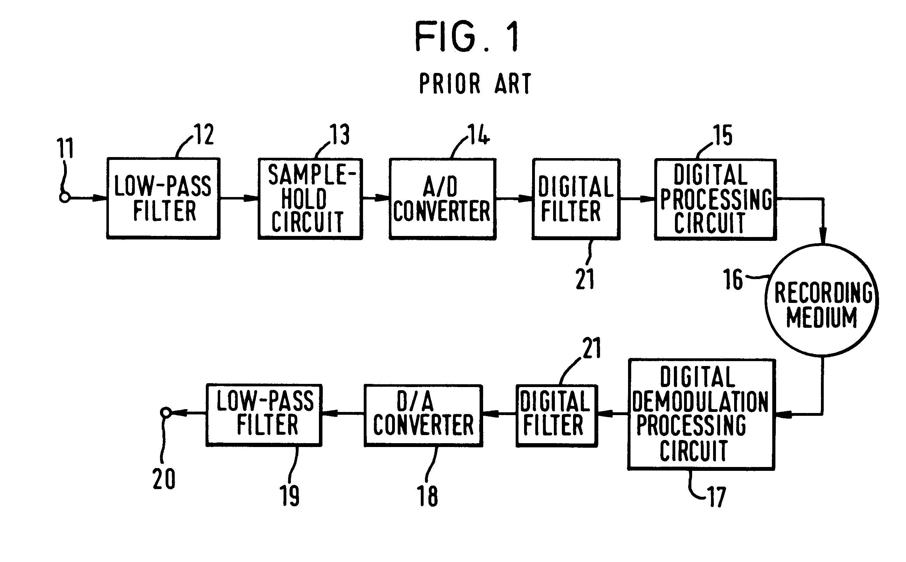

In the recent years, widespread use has been made of digital recording and play-back units such as PCM recorders or DAD (digital audio disc) players utilizing PCM (pulse code modulation) techniques in order to enable audio equipment to be produced with a fidelity which is as high as possible. Fig. 1 is a diagram of the essential configuration of a digital recording and play-back unit. First of all, an analogue signal such as an audio signal supplied at an input terminal 11 has its unwanted high-frequency components removed by a low-pass filter 12. It is then supplied to a sample-hold circuit 13, which samples the analogue signal at intervals of the period of a prescribed sampling frequency (e.g., 44.1 KHz in the case of a DAD player). This sampled analogue signal is converted to a digital signal by quantization and encoding by means of an A/D (analog to digital) converter 14. Processing consisting of the addition of an error correction code and digital modulation is then carried out by a digital processing circuit 15. The signal is then recorded on a recording medium 16 such as a tape or a disc. The original digital signal is then recovered by taking the play-back signal that is fetched from the recording medium 16 during play-back, and performing error correction for errors resulting from defects in the recording medium 16 etc., and demodulation, by means of a digital demodulation processing circuit 17. This digtal signal is extracted as a continuous analogue signal, i.e., the original audio signal, from the output terminal 10, by removing the high-frequency noise component by a low-pass filter 19, after step-wise conversion to an analogue signal by means of a D/A (digital to analog) converter 18.

However, with such a digital recording and play-back unit, when the analogue signal is recovered by sampling, high-frequency components are generated that are aliased about the sampling frequency to frequency components contained in the original signal. This results in a high-frequency distribution in the neighbourhood of the upper limit of the original frequency band. The low-pass filter 19 therefore has to have a steep filter characteristic in order to remove these. If, however, a digital filter 21 is inserted after the A/D converter 14 or before the D/A converter 18, to remove the high-frequency components is the digital signal stage, it is not necessary to make the filter characteristic of the low-pass filter 19 so steep.

Here, the digital filter 21 is explained more detail. Generally there are two operations for providing digital data with filtering characteristic. One is the operation in a frequency domain, and the other is the operation in a time domain. The former filtering operation is made by the steps of a fast Fourier translation (FFT) of an input digital data sequence $\{x(t)\}$ in the time domain into a digital data $X(w)$ in the frequency domain, a multiplication of the digital data $X(w)$ with a transmission function $G(w)$ having a predetermined characteristic in the frequency domain, and then an inverse fast Fourier translation (IFFT) of the product $Y(w)$ between the data $X(w)$ and the transmission function $G(w)$ into an output data sequence $\{y(t)\}$ in the time domain. However the former filtering operation fails to be prosecuted in a real time to follow the occurence of the input digital data sequence $\{x(t)\}$, in the case of a data sequence $\{x(t)\}$ occupying a relatively long time. Further, hardware for the FFT and the IFFT is required formed of very complicated and large scale circuit apparatus.

The later filtering operation, on the other hand, is made by the step of a convolution algorithm between the input data sequence in the time domain $\{x(t)\}$ and an impulse response sequence $\{g(i)\}$ ($i = 0, 1, ..., m$). The convolution algorithm for the later filtering operation is expressed as follows:

$$y(t) = \sum_{i} g(i) \cdot x(t-i)$$

where y(t) represents filterd output digital data sequence.

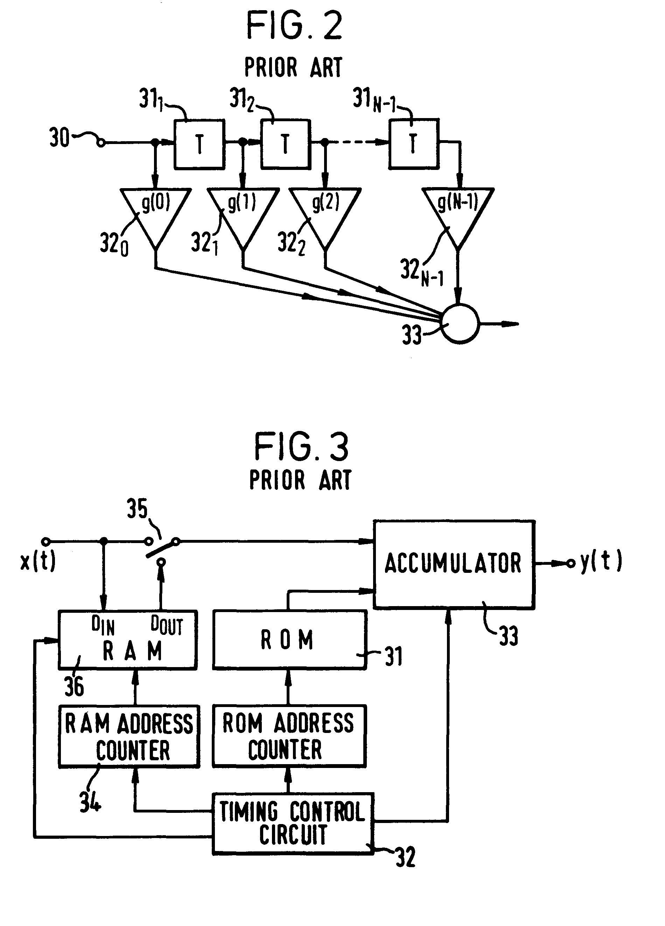

Conventional circuit arrangements for carrying out the convolution algorithm are illustrated in Figs. 2 and 3, reproduced from a paper titled "FIR Filter and Digital Signal Processing", "Musen to Jikken, Separate Volume", issued on November 20, 1979, pp. 89-96. The article "Digitales Transversalfilter als universeller Signalprozessor" in Elektronik 1980 Heft 20 also discloses such a conventional circuit arrangement. The circuit shown in Fig. 2 is a basic arrangement for prosecuting the convolution algorithm. In Fig. 2, an input terminal 30 receives a digital data sequence x(t) consists of a plurality of codewords (e.g., of 16 bits per word) obtained through the analog-to-digital (A/D) conversion of an analog signal at sampling frequency w. The sequence x(t) is given to a delay device 31 composed of N-1 delay elements $31_1$ through $31_{N-1}$, each having a delay time T equal to the sampling period $1/F_S$. The outputs x(t) to x(t-N+1) of the delay elements $31_1$ through $31_{N-1}$ are sent to multipliers $32_0$ through $32_{N-1}$, each having a corresponding filter coefficient g(i) (i = 0, 1, ..., N-1) derived from a desired impulse response or frequency transfer function. The outputs of the multipliers $32_0$ through $32_{N-1}$ are sent to an adder 33 to give an output codeword sequence y(t). Such a structure enables the achievement of the required filtering characteristics by appropriately varying the coefficients g(i).

The conventional circuit shown in Fig. 2, however, also required a large number of delay elements and multipliers to calculate the convolution algorithm of higher order.

The circuit arrangement shown in Fig. 3, proposed for improving the basic circuit shown in Fig. 2, includes memories for storing an input data sequence x(t) and a corresponding filter coefficient g(i). In Fig. 3, the set of coefficient data g(k), which are set beforehand, are stored in a ROM(read-only memory) 31. These coefficient data g(k) are sequentially read out by an address signal provided from an address counter 34, and fed to an accumulator 33. The input signal x(t), which constitutes the other data sequence of the convolution arithmetic calculation, is supplied from the outside at the prescribed intervals. For example, as shown in the drawing, the input signal x(t) may be temporarily applied to the accumulator 33 through a gate 35 or a data input terminal $D_{IN}$ of a RAM (read/write memory) 36 with the correct timing. The gate 35 selects the applying the input signal x(t) from the outside and from the RAM 36 to the accumulator 33. The RAM 36 stores the input signal x(t) at the prescribed time and is usually in a read-mode so that it supplies the already-stored input signals to the accumulator 33 through the gate 35. Both designation of the operating mode (read/write mode) and an address operation for the RAM 36 are carried out by a timing control circuit 32 which is usually operated using microcomputor software. The timing control circuit 32 also points the address of the ROM 31 and further controls the operation mode of the RAM 36 and a timing of data outputting from the accumulator 33.

We shall now give a simple explanation of the flow of operations of the above-mentioned convolution arithmetic circuit shown in Fig. 3. We shall take as an example the case where calculation of

$$y(t) = \sum_{k=0}^{m} g(2k) \cdot x(t-k)$$

is performed. First of all, the timing control circuit 32 points the addresses to enable sequential reading of the coefficient data g(2), g(4), ..., g(2m) that are already stored in the ROM 31 and the input signals x(t-1), x(t-2), ..., x(t-m) that are already stored in the RAM 36 in accordance with the correspondence relationship that g(2k) corresponds to x(t-k). The data which are thus read are supplied to the accumulator 33, where they are successively multiplied and then respective results-thus mulitiplied are added. During this time, a R/W (designating read/write) signal that is outputted from the timing control circuit 32 is at L (low) level, so the RAM 36 is in the read-mode, and the R/W signal is applied to a select terminal (not shown) of the gate 35, so that the input of the input signal x(t) supplied from a external device of outside is disabled. Also, before the timing control circuit 32 performs the above operation, or at a suitable time during its progress, the R/W signal is changed to H (high) level, putting the RAM 36 into a write-mode, and the gate 35 into connection to the external device, so that a latest input signal x(t) is fed to the accumulator 33 and the RAM 36. Also at this time, the timing control circuit 32 points the addresses of the ROM 31 and the RAM 36 so that the coefficient data g(k) corresponding to the input signal x(t) is read out from the ROM 31 and the latest input signal x(t) is stored in the prescribed address in the RAM 36 ready for use in the next calculation. When the stage is reached where all the data of convolution algorithm

$$y(t) = \sum_{k=0}^{n} g(2k) \, x(t-k)$$

to be performed have been inputted, the accumulator 33 outputs the result of its convolution calculation, in response to an output control signal from the timing control circuit 32.

Thus, the architecture of a convolution arithmetic circuit such as has been thought of in the exisitng technology involves storing, in prescribed locations in the memory, two sets of data, relating to the convolution calculation between the input signal x(t) (multiplicand data) and the coefficient data g(k), and supplying these sequentially to an accumulator in accordance with a corespondence relationship, all these operations being controlled by microcomputer software.

The above conventional convolution arithmetic circuit has a certain universality in that it makes use of microcomputer software. However, if such a convolution arithmetic circuit were to be selected for a digital filter to be used in a DAD circuit, there would be problems regarding the processing speed of the

EP 0 143 632 B1

microcomputer software, with the result that the convolution arithmetic circuit would be unable to cope with the flow of the other signal processing systems. Sometimes this would be very inconvenient. Specifically, in a digital filter used in a digital recording and play-back unit as described above, the input signal x(t) is sampled at the sampling interval before being inputted sequentially, so the signal processing, in other words the convolution algorithm, has to be performed in real time. This results in high-order calculation, since the sampling number of the coefficient data g(k) that are used in the convolution algorithm has to be fairly large, due to the need to set a transmission function, i.e., a filter characteristic, for the digital filter, that will enable it to deal with signals containing a large number of high-frequency components. Because of this, since, as mentioned above, all the address signals etc. must be controlled by the microcomputer software, the load on a CPU (central processing unit) of the microcomputor becomes too great, making it impossible to carry out the arithmetical processing in a fixed time. Such problems become more marked as the complexity of the calculations increases, and have set limits to the signal processing capabilities that could be achieved in practice by convolution arithmetic circuits.

The present invention seeks to provide a convolution arithmetic circuit suitable for a real-time processing of digital signals and which has a simple construction for setting a convolution formula between data to be calculated optionally.

According to the present invention there is provided a convolution arithmetic circuit comprising:

accumulating means for sequentially multiplying and adding multiplicand data and coefficient data constituting respective elements of two digital data sequences;

a first memory for storing, of said two digital data sequences that are supplied to said accumulator, the coefficient data sequence;

a second memory for storing the multiplicand data sequence of said two digital data sequences;

first, scale-of-N, count means for pointing the address from which the coefficient data stored in said first memory are to be sequentially read;

second, scale-of-$N/_a$, count means (where a is a natural number) for pointing the address for reading the stored multiplicand data from said second memory or for writing the multiplicand data, constituted by an input signal, into said second memory;

means for generating a signal specifying the operating mode, read or write, of said second memory; and

means for introducing the input signal into said second memory and said accumulating means when said second memory is in write mode;

characterised in that

the convolution arithmetic circuit also includes means coupled to the counter outputs of said first or second count means for receiving a count value of said first or second count means, and for generating a control signal that temporarily alters the output of said second count means at a prescribed count value of said first or second count means.

For a better understanding of the present invention reference will now be made, by way of example, to the accompanying drawings, in which:-

Fig. 1 is a block diagram of the essential construction of a digital recording and play-back unit.

Fig. 2 and Fig. 3 are circuit diagrams showing 5 conventional convolution arithmetic circuits that have been previously proposed.

Fig. 4 is a circuit diagram of a first embodiment of a convolution arithmetic circuit according to this invention.

Fig. 5 is a circuit diagram showing the detailed configuration of a part of the convolution arithmetic circuit shown in Fig. 4.

Fig. 6 is a timing chart given in explanation of the operation of the first embodiment.

Fig. 7 is a circuit diagram of a second embodiment of a convolution arithmetic circuit according to this invention.

Fig. 8 is a timing chart given in explanation of the operation of the second embodiment.

Fig. 9 is a circuit diagram of a third embodiment of a convolution arithmetic circuit according to this invention.

Fig. 10 is a timing chart given in explanation of the operation of the third embodiment.

Fig. 11 is a circuit diagram of a fourth embodiment of a convolution arithmetic circuit according to this invention.

Fig. 12 and Fig. 13 are timing charts given in explanation of the operation of the fourth embodiment.

Fig. 14 is a circuit diagram of a fifth embodiment of a convolution arithmetic circuit according to this invention.

Fig. 15 is a timing chart given in explanation of the operation of the fifth embodiment.

4

Fig. 16 is a circuit diagram of a sixth embodiment of a convolution arithmetic circuit according to this invention.

Fig. 17 is a timing chart given in explanation of the operation of the sixth embodiment.

Embodiments of the present invention are described below with reference to the accompanying drawings. In the embodiments, it is assumed that coefficient data and multiplicand data in a convolution algorithm are both 16-bit signals. However, in fact they could be signals of any bit length.

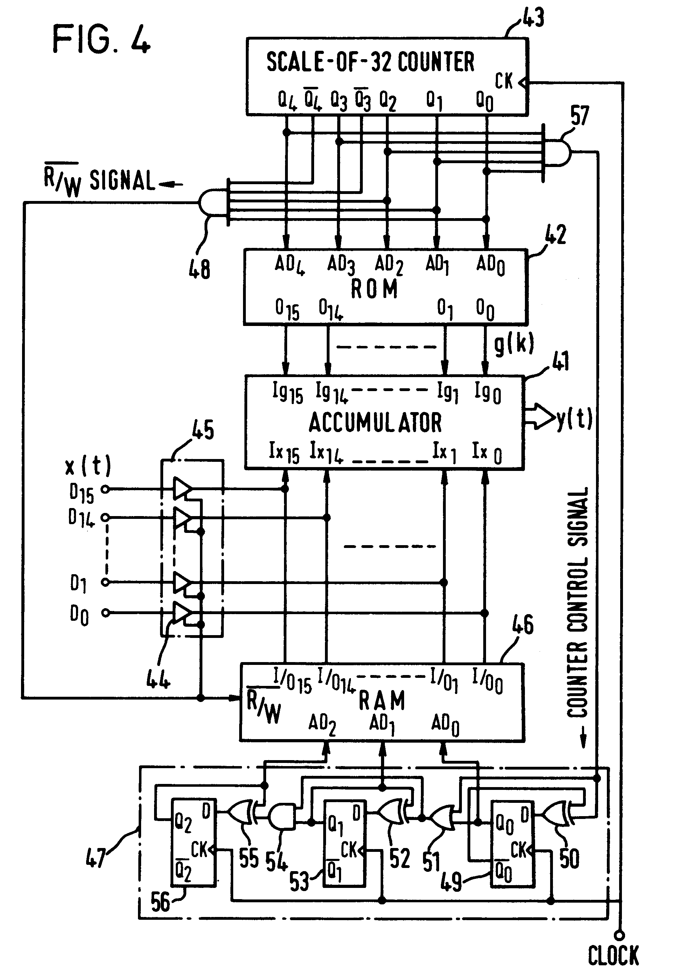

Fig. 4 shows a circuit configuration of an embodiment (first embodiment) in a convolution arithmetic circuit according to this invention. In this embodiment, the sampling number of the coefficients g(k) is set at 32. In Fig. 4, the sets of input terminals $Ig_0$ to $Ig_{15}$ of an accumulator 41 is connected to output terminals $O_0$ to $O_{15}$ of a ROM 42 that stores the coefficient data g(0) to g(31). Address input terminals $AD_0$ to $AD_4$ of the ROM 42 are connected to output terminals $Q_0$ to $Q_4$ of a synchronous scale-of-32 counter 43. Other input terminals $Ix_0$ to $Ix_{15}$ of the accumulator 41, to which the multiplicand data are applied, receive, with the prescribed timing (to be discribed later), input signals x(t) (the data of each bit are $D_0$, $D_1$, ...., $D_{15}$) that are supplied from an external device through a gate 45 that has, arranged in parallel with it, 16 number of tri-state buffers 44, corresponding to each bit. They are also connected to input/output (I/O) terminals $I/O_0$ to $I/O_{15}$ of a RAM 46, which holds the plurality of input signals already stored in preceding stages; these constitute the multiplicand data. Address signals that are applied to the address input terminals $AD_0$ to $AD_4$ of the RAM 46 are generated by a scale-of-8 variable counter (to be described later) 47 and supplied from its output terminals $Q_0$ to $Q_2$. An $\overline{R/W}$ signal that specifies the operating mode of the RAM 46 is generated by a 5-input AND gate 48, whose five inputs are connected the output terminals $Q_0$, $Q_1$ $Q_2$, $\overline{Q}_3$ and $\overline{Q}_4$ of the scale-of-32 counter 43. The R/W signal that is thus generated and controlled is supplied to the RAM 46 and the gate 45. In one mode the R/W signal permits the supply to the RAM 46 and the accumulator 41, of the input signal x(t) that is then applied on input terminals of each of the tri-state buffers 44.

The scale-of-8 variable counter 47 will now be described. The scale-of-8 variable counter 47 consists of three DFFs (D-type flip-flops) and is a three-bit synchronous counter that counts the same clock signal CLOCK as the scale-of-32 counter 43 mentioned earlier. An exlclusive OR gate 50 is arranged on the input side of the first DFF 49, and the output terminal $Q_0$ of the first DFF 49 is connected to the input terminal D of the second DFF 53 by means of a two-input OR gate 51 and an exclusive OR gate 52. The output terminal $Q_1$ of the second DFF 53 is connected to the input terminal D of the third DFF 56 through a 2-input AND gate 54 and an exclusive OR gate 55. A counter control signal (to be described later) is applied to one terminal of the exclusive OR gate 50, and the inverse output $\overline{Q}_0$ of the first DFF 49 is fed back to its input terminal D through the exclusive OR gate 50 on the other side. The 2-input OR gate 51 receives as its input the counter control signal and the non-inverse output $Q_0$ of the first DFF 49. The exclusive OR gate 52 receives as its input the non-inverse output $Q_1$ of the second DFF 53 and the output of the 2-input OR gate 51. The 2-input AND gate 54 receives as its input the output of the 2-input OR gate 51 and the non-inverse output $Q_1$ of the second DFF 53. The exclusive OR gate 55 receives as its input the non-inverse output $Q_2$ of the third DFF 56 and the output of the 2-input AND gate 54. The DFFs 49, 53 and 56 of the respective stages are operated by a rising end of the clock signal CLOCK, and their non-inverse outputs $Q_0$ to $Q_2$ provides the RAM 46 the address signal (RAM address). The counter control signal is generated by the 5-input AND gate 57 that is connected to the output terminals $Q_0$ to $Q_4$ of the scale-of-32 counter 43, and constitute the enable signal that is inputted to the scale-of-8 variable counter 47. The count of the scale-of-8 variable counter 47 changes as follows, in response to the level state of the counter control signal. The scale-of-8 variable counter 47 performs an ordinary counter operation, inverting levels of the outputs $Q_0$ and $\overline{Q}_0$ of the first DFF 49 synchronously with the clock signal CLOCK, while the counter control signal is at level L. However, when the counter control signal at H level is inputted, the scale-of-8 variable counter 47 holds the output level of the first DFF 49 and inverts the output level of the second DFF 53. That is, while the count value of the scale-of-8 variable counter 47 is incremented by +1 with every clock signal CLOCK if the counter control signal is at L level, if the counter control signal is at H level, the count of the counter control signal will be incremented by +2.

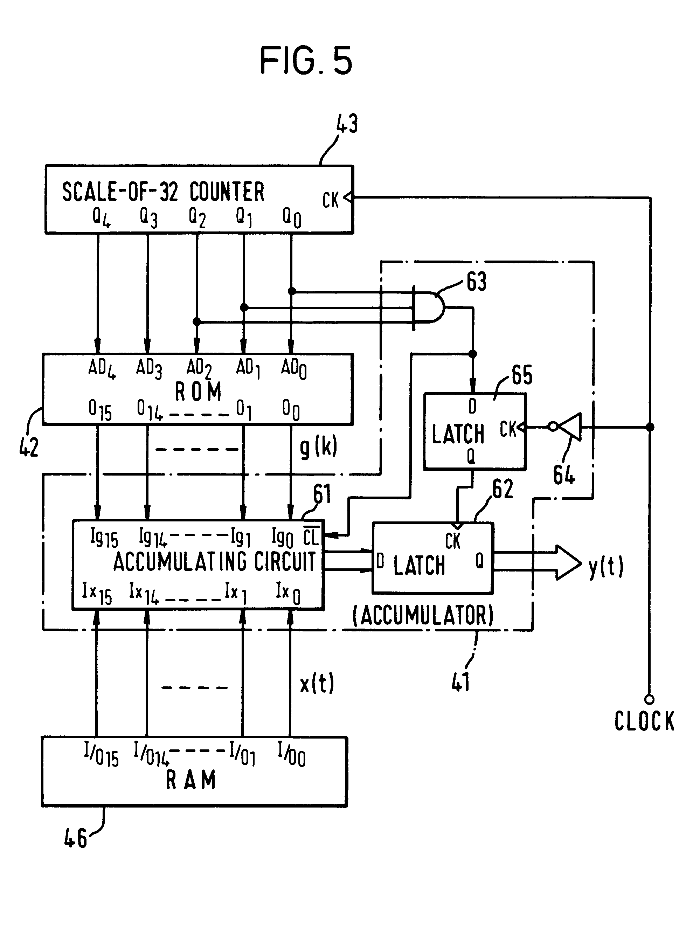

Also, as shown in detail in Fig. 5, the accumulator 41 referred to above is equipped with an accumulating circuit 61 whose structureal elements are multipliers and adders, and with a latch circuit 62 that latches an output of the foregoing accumulating circuit 61. Additionally, the accumulator 41 is provided with a 3-input AND gate 63 which receives as its inputs the least-significant 3-data bits of the scale-of-32 counter 43, and a latch circuit 65 that latches an output of the 3-input AND gate 63 with a rising edge of a chock signal obtained by inverting, by means of an inveter 64, the input clock signal CLOCK of the scale-of-32 counter 43. Thus the output of the 3-input AND gate 63 is delivered as data input to the latch circuit 65, and constitutes a clear signal CLEAR for the accumulating circuit 61. Thus the output of the accumulating circuit 61 consists of the result of sequential addition of the values obtained by multiplying the outputs g(k) of the ROM 42 and the output x(t) of the RAM 46, but is cleared by the falling CLEAR signal. The latch circuit 62 receives as its data input the output of the accumulating circuit 61 and as its clock input the output Q of the latch circuit 65. The data that is latched in the latch circuit 62 constitutes the output of the accumulator 41, i.e., the output data y(t) of the convolution arithmetic circuit.

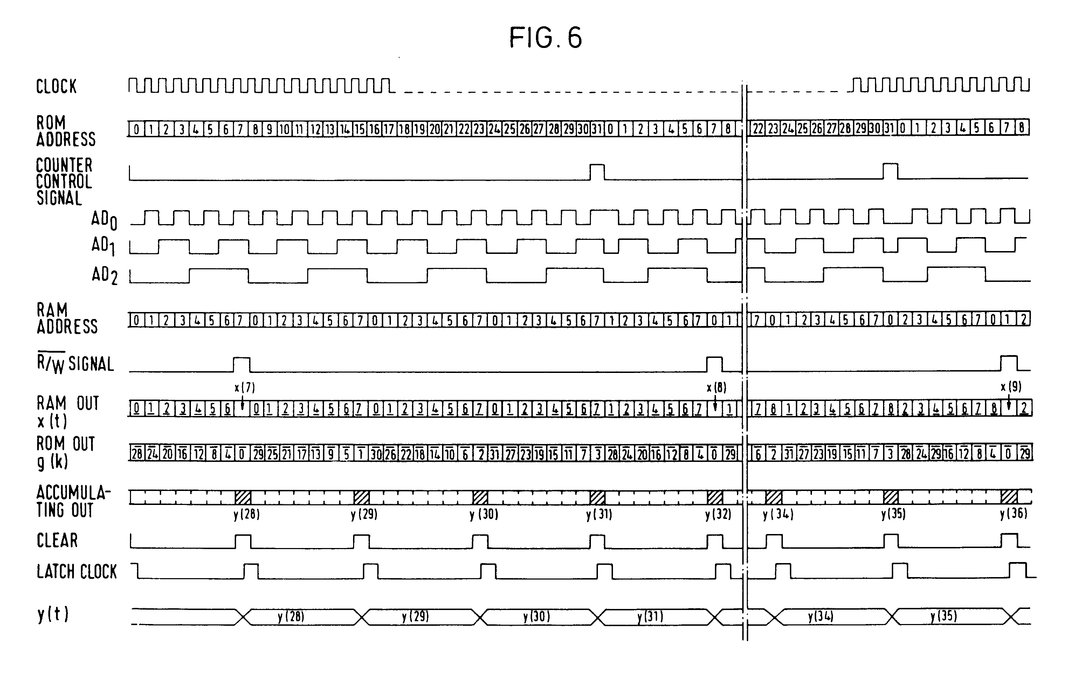

The operation of the above embodiment will now be explained with reference to Figs. 4 and 5 and also Fig. 6. In this case, the convolution arithmetic circuit of Fig. 4 increases the sampling frequency by a factor of 4 by performing calculations defined by the follolwing equations:

$$y(4t) = \sum_{j=0}^{7} g(4j) \cdot x(t-j)$$

$$y(4t+1) = \sum_{j=0}^{7} g(4j+1) \cdot x(t-j)$$

$$y(4t+2) = \sum_{j=0}^{7} g(4j+2) \cdot x(t-j)$$

$$y(4t+3) = \sum_{j=0}^{7} g(4j+3) \cdot x(t-j)$$

The convolution operation is executed four times while the input signal x(t) is sampled once, thereby making the sampling frequency of the output data y(t) four times the sampling freqiency of the input signal x(t). Actually, it is worth noting that the variable $(4t + \alpha)$ of the ouput data $y(4t + \alpha)$ (where $\alpha = 0, 1, 2, 3$) of the above equations is on the time domain, so the ouput data is, in fact,

$$y(\frac{4t + \alpha}{4})$$

with respect to the input data x(t), though the variable is expressed in interger form, i.e., in the former form $y(4t + \alpha)$ for convenience.

Consequently, if we describe this convolution operation along the time-chart shown in Fig. 6 (this Figure shows the input signal from the stage of x(7), part being omitted), first of all the scale-of-32 counter 43 counts up in synchronism with the rising edge of the input clock signal CLOCK as aforementioned, and the address (ROM address) for the ROM 42 changes through 0, 1, 2, ...., 31, 0, 1,,... in accordance with the output of the scale-of-32 counter 43. Also, with the same timing, the output of the scale-of-8 variable counter 47 is applied to the address terminals $AD_0$ to $AD_2$ of the RAM 46 to change the address (RAM address) through 0, 1, 2, ...., 7, 0, 1, ... . In this case, the coefficient data g(28), g(24), g(20), ..., g(0) (expressed as $\overline{28}$, $\overline{24}$, $\overline{20}$, ...., $\overline{0}$ in Fig. 6) are stored in the ROM 42 at the ROM addresses 0, 1, 2, ...., 7 and are read out sequentially. The multiplicand data x(0), x(1), x(2), ...., x(6) (expressed by $\overline{0}$, $\overline{1}$, $\overline{2}$, ...., $\overline{6}$ in Fig. 6) corresponding to these coefficient data are stored at the RAM addresses 0, 1, 2, .... 6 and are read out from the RAM 46. Meanwhile, the accumulator 41 finds the products of these coefficient data and multiplicand data which are inputted to the accumulator 41, and adds up the results as a running total. That is, the accumulator 41 calculates $g(28)\cdot x(0) + g(24)\cdot x(1) \; g(20)\cdot x(2) + .... + g(0)\cdot x(6)$. The cumulative added output is sent from the accumulating circuit 61 to the latch circuit 62 (Fig. 4). It should be noted that, during the period in which the count of the scale-of-32 counter 43 is between "0" and "6", the $\overline{R/W}$ signal and the counter countrol signal are both L level When the count of the scale-of-32 counter 43 reaches "7", signals "1" (H level) are applied to all of the input terminals of the 5-input AND gate 48, and the $\overline{R/W}$ signal becomes H level, causing the RAM 46 to change to write-mode and the gate 45 in the high impedance state to be released to allow the latest input signal x(7) presently applied on the the gate 45 to be written in the RAM address "7" of the RAM 46. The input signal x(7) is now supplied to the accumulator 41 in place of the output of the RAM 46, and the input signal x(7) is multiplied b the coefficient data g(0) corresponding to the ROM address "7". Thus the accumulator 41 makes the final calculation for calculating the output data y(28) corresponding to the input signal x(7). At the time when this calculation is completed, the accumulating output from the accumulating circuit 62 corresponds to

$$y(28) = \sum_{j=0}^{7} g(4j) \cdot x(7-j).$$

When the count of the scale-of-32 counter 43 is "7", the outputs $Q_0$ to $Q_2$ of the least-significant 3-data bits of the counter 43 all become "1". The 3-input AND gate 63 shown in Fig. 5 therefore outputs an H level signal. On the fall of the input clock signal CLOCK, i.e., the rise of the inverted clock signal from the inverter 64, the latch circuit 65 transfers the H level signal, as a clock signal (latch clock), to the latch circuit 62, with a delay of one-half of the input clock signal's interval. Consequently, once the accumulating output y(28) has been determined, the latch circuit 62 latches the value of the output data y(28), and outputs the data y-(28) as the output of the convolution arithmetic circuit up to the time of the next latch clock. Also, the output of the 3-input AND gate 63 is applied to a CLEAR teminal $\overline{CL}$ of the accumulating circuit 61, so that the accumulating circuit 61 is cleared on the falling edge of this CLEAR signal, i.e., at the timing of the count of the scale-of-32 counter 43 shifting to "8", so that the accumulating circuit 61 becomes ready for the next calculation.

After the output data y(28) has thus been calculated, with the change of the $\overline{R/W}$ signal to L level, the RAM 46 returns to the read-mode. The read-mode continues until the count of the scale-of-32 counter 43 again becomes "7". When this happens, the RAM address again shifts through 0, 1, 2, ..., 7 by the scale-of-8 variable counter 47, causing the multiplicand data x(0), x(1), x(2), ...., x(7) corresponding to the RAM addresses to be read. Now the input signal x(7) in the preceding cycle has already been stored in the RAM address "7". Also, the corresponding coefficient data g(29), g(25), g(21), ..., g(1) whose ROM addresses are the outputs 8, 9, 10, ...., 15 of the scale-Of-32 counter 43 are outputted from the ROM 42, so that the accumulator 41 can caluculate g(29)•x(0) + g(25)•x(1) + g(21)•x(2) + .... + g(1)•x(7). Thus, when the count of the scale-of-32 counter (43) is "15", i.e., when the outputs $Q_0$ to $Q_2$ of the least-significant 3-data bits of the scale-of-32 counter 43 has been again become all "1" (H level), the accumulating output is latched, as in the operation of the preceding stage, on the rising edge of the latch clock signal. The latched output data is now

$$y(29) = \sum_{j=0}^{7} g(4j+1) \cdot x(7-j).$$

The accumulating circuit 61 is cleared by the falling edge of the CLEAR signal when the count of the scale-of-32 counter 43 shifts to "16". These operations are carried out continuously. While the count of the scale-of-32 counter 43 is shifting from "16" to "23", the coefficient data g(30), g(26), g(22), ...., g(2) corresponding to the ROM addresses 16, 17, 18, .., 23, are read out from the ROM 42, and the multiplicand data x(0), x(1), x(2), ...., x(7), are read out from the RAM 46 in accordance with the RAM address specified by the scale-of-8 counter 47. Thus the accumulator 41 calculates g(30)•x(0) + g(26)•x(1) + g(22)•x(2) + .... + g(2)•x(7) with the same timing as in the preceding stage and delivers the output data

$$y(30) = \sum_{j=0}^{7} g(4j+2) \cdot x(7-j).$$

Also, while the count of the scale-of-32 counter 43 shifts from "24" to "31", the coeffieient data g(31), g(27), g(23), ...., g(3) at the ROM addresses corresponding to this current value are read out from the ROM 42. These are supplied to the accumulator (41) in synchronism with the multiplicand data x(0), x(1), x(2), ...., x-(7) that are read out from the RAM 46. The accumulator (41) therefore performs the calculation g(31)•x(0) + g(27)•x(1) + g(23)•x(2) + ..... + g(3)•x(7), so that the output data

$$y(31)$$

$$= \sum_{j=0}^{7} g(4j+3) \cdot x(7-j)$$

is obtained. At this time, all the coefficient data stored in the ROM 42 will have been read out, and, at the same time, the series of convolution calculations for which the input signal x(7) is the most recent multiplicand data will have been completed.

However, in the above convolution operation, when the final address is pointed, i.e., when the count of the scale-of-32 counter 43 is "31", the outputs $Q_0$ to $Q_4$ of the scale-of-32 counter 43 of "1" (H level) are applied to all of the input terminals of the 5-input AND gate 57 shown in Fig. 4, with the result that the counter control signal which the 5-input AND gate 57 outputs changes to H Level. Consequently, in the scale-of-8 variable counter 47, the output of the first DFF 49 is held for the following clock, as described earlier, and the output of the second DFF 53 is inverterd. As a result, the next RAM address is incremented by +2 with respect to the previous address, shifting from "7" to "1".

In the following convolution calculation, therefore, while the ROM address shifts through 0, 1, 2, ...., 6, 7, the RAM address shifts through 1, 2, 3, ...., 7, 0. Further, when the count of the scale-of-32 counter 43 becomes "0", the $\overline{R/W}$ signal goes to H Level, and a fresh input signal x(8) is fed to the RAM 46 and the accumulator 41. The accumulator 41 therefore receives as its inputs the coefficient data and the multiplicand data in the correspondence relationship g(28), g(24), g(20), ...., g(0) respectively corresponding to x(1), x(2), x(3), ..., and x(8). The accumulator 41 therefore carries out the accumulation of g(28)•x(1) + g(24)•x(2) + g(20)•x(3) + .... + g(0)•x(8), and delivers the output data

$$y(32) = \sum_{j=0}^{7} g(4j)\, x(8-j)$$

Also, the latest input signal x(8) is stored in the RAM address "0" of the RAM 46 for the next calculation. That is, the lates data x(8) is written in the RAM 46 in place of the oldest data x(0) of the previously stored multiplicand data. Thus the multiplicand data read out from the RAM 46 are the input data, successively stored when the count of the scale-of-32 counter 4 becomes "7".

Thus, after calculating the output data y(32) as above, the same sequence of operations occurs as when the series of convolution calculations were performed using the input signal x(7), referred to above, as the most recent multiplicand data for the coeffieient data read out from the corresponding ROM addresses. The corresponding RAM addresses are repeated in the cycle 1, 2, 3, ..., 7, 0 every time the convolution calculation is performed in each of the stages until the count of the scale-of-32 counter 43 reaches "31". The multiplicand data are therefore successively read out repictitively in the order of x(1), x(2), x(3), ...., x(7), x(8). The accumulator 41 therefore performs the convolution calculation taking the input signal x(8) as the most recent multiplicand data. Thus the output data

$$y(33) = \sum_{j=0}^{7} g(4j+1)\cdot x(8-j), \; y(34) = \sum_{j=0}^{7} g(4j+2)\cdot x(8-j)$$

and

$$y(35) = \sum_{j=0}^{7} g(4j+3)\cdot x(8-j)$$

are obtained when the count of the scale-of-32 counter 43 is "15", "23" and "31" respectively.

When the count of the scale-of-32 counter 43 again becomes "31", the counter control signal changes to H level and the RAM address shifts from "0" to "2". When the count of the scale-of-32 counter 43 becomes "7", the $\overline{R/W}$ signal goes to H level and the most recent data x(9) is written in the RAM address "1" where the oldest multiplicand data x(1) had been formerly held. Subsequent operation is as already described. The RAM address shifts by 1 every time the input signals x(t) are succesively received. The convolution algorithm is executed four times with the respective input signal constituting the most recent multiplicand data in each case.

Summarizing, an example of part of the convolution calculation performed in this embodiment is as given below:

y(28) = g(0)•x(7) + g(4)•x(6) + g(8)•x(5) + .... + g(24)•x(1) + g(28)•x(0)

y(29) = g(1)•x(7) + g(5)•x(6) + g(9)•x(5) + .... + g(25)•x(1) + g(29)•x(0)
y(30) = g(2)•x(7) + g(6)•x(6) + g(10)•x(5) + .... + g(26)•x(1) + g(30)•x(0)
y(31) = g(3)•x(7) + g(7)•x(6) + g(11)•x(5) + .... + g(27)•x(1) + g(31)•x(0)
y(32) = g(0)•x(8) + g(4)•x(7) + g(8)•x(6) + .... + g(24)•x(2) + g(28)•x(1)
y(33) = g(1)•x(8) + g(5)•x(7) + g(9)•x(6) + .... + g(25)•x(2) + g(29)•x(0)

It can be verified that the above calculations are in accordance with the definitions given earlier.

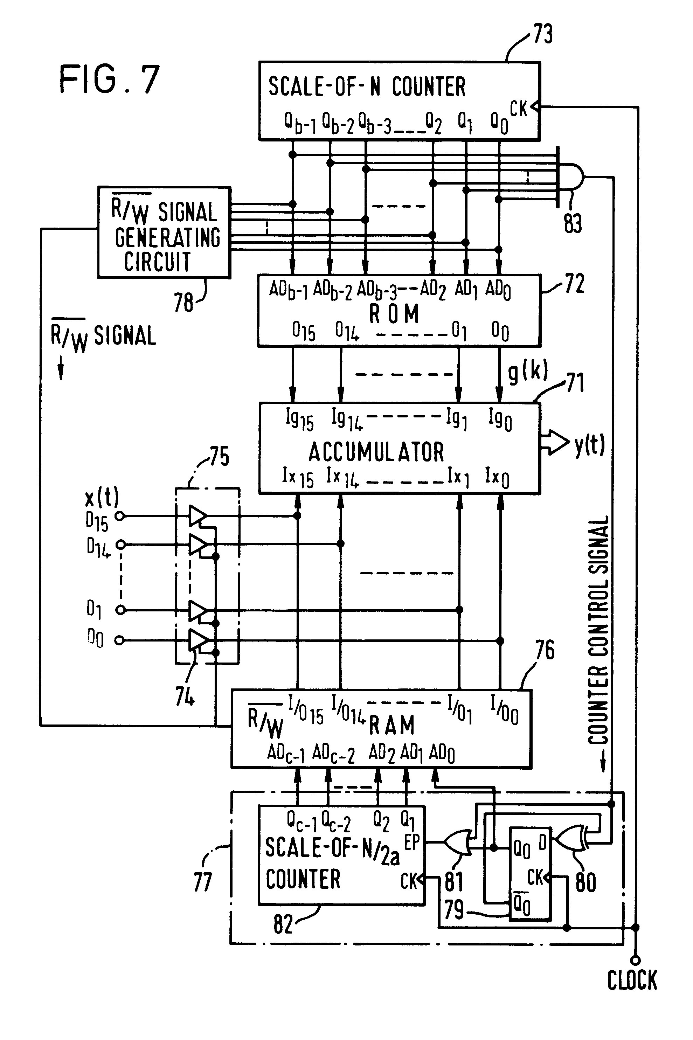

Another embodiment of the convolution arithmetic circuit of this invention will now be described. Fig. 7 shows the circuit configuration of the other embodiment (second embodiment) of this invention. The second embodiment is a generalization of the preceding first embodiment. Specifically, the second emdodiment consists of a convolution arithmetic circuit in which the sampling frequency is increased by a factor of a. In the following description of the second embodiment, a description of parts which are identical in construction or function to corresponding parts in the foregoing first embodiment will be omitted. Address operation for the ROM 72 that supplies the coefficient data g(k) to the accumulator 71 is performed by a scale-of-N counter 73. The ROM 72 stores a number N of coefficient data. The input signals x(t) that constitiute the multiplicand data are fed to the RAM 76 and the accumulator 71 at the appropriate time through the gate 75 which has arranged in parallel with it a plurality of the tri-state buffers 74. The address operation for the RAM 76 is performed by a scale-of-$^N/_a$ variable counter 77 conected to the address terminals $AD_0$ to $AD_{C-1}$ of the RAM 76. The RAM 76 supplies the multiplicand data which have been stored during the read-mode period of the RAM 76 to the accumulator 71 in response to the address signals outputted from the scale-of-$^N/_a$ variable counter 77. An $\overline{R/M}$ signal generating circuit 78 is connected to output terminals $Q_0$ to $Q_{b-1}$ of the scale-of-N counter 73. The $\overline{R/W}$ signal is fed to the the tri-state buffers 74 of the gate 75 and to the RAM 76, to control the acceptance of the input signal x(t) and the operating mode of the RAM 76. In the scale-of-$^N/_a$ variable counter 77, the exclusive OR gate 80 is arranged on the input side of the first DFF 79 in the same way as in the scale-of-8 variable counter 47 shown in Fig. 3. The inputs to the exclusive OR gate 80 are the inverse output $Q_0$ of the first DFF 79, and the counter control signal. The non-inverse output $Q_0$ of the first DFF 79 is supplied to the address terminal $AD_0$ of the RAM 76, and the counter control signal is applied to the other input terminal of the two-input OR gate 81. The output of the 2-input OR gate 81 constitutes an enable signal which is supplied to an ordinary scale-of-$^N/_{2a}$ counter 82, connected to the address terminals $AD_1$ to $AD_{c-1}$ of the RAM 76. The counter control signal is generated by the AND gate 83 connected to the non-inverse outputs $Q_0$ to $Q_{b-1}$ of the scale-of-N counter 73. Thus, when the counter control signal becomes H level, i.e., when the count of the scale-of-N counter 73 is "N-1", the scale-of-$^N/_a$ variable counter 77 is incremented by +2 with the following clock signal.

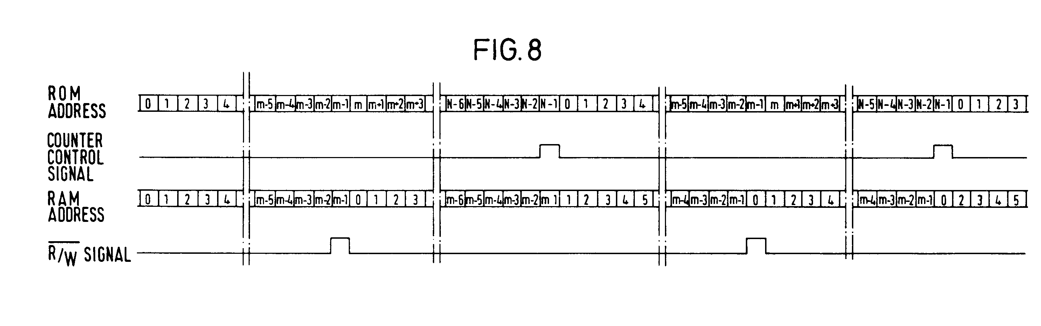

The operation of this embodiment will now be explained with reference to Fig. 7 and Fig. 8. The convolution arithmetic circuit according to the second embodiment is constructed so as to step up the sampling frequency by a factor a, using the N number of coefficient data. It executes repetitively a series of a nmumber of convolution calculations as defined by the following equations, in every sampling period of the input signal x(t).

$$g(at) = \sum_{j=0}^{m-1} g(aj) \cdot x(t-j)$$

$$g(at+1) = \sum_{j=0}^{m-1} g(aj+1) \cdot x(t-j)$$

$$g(at+2) = \sum_{j=0}^{m-1} g(aj+2) \cdot x(t-j)$$

$$\vdots$$

$$g(at+a-1) = \sum_{j=0}^{m-1} g(aj+a-1) \cdot x(t-j)$$

In the above equations, m has been written instead of $^N/_a$. Thus the number of coefficient data and the number of multiplicand data used in the first convolution calculation become m respectively. The actual accumulation operation will now be explained with reference to the timing chart shown in Fig. 8. To make the Fig. 8 easier to understand, the drawing shows only the counter control signal, the $\overline{R/W}$ signal, the RAM address which is the output from the scale-of-$^N/_a$ variable counter 77, and the ROM address which is the output from the scale-of-N counter 73. These are the most important items, that determine the flow of operations in the convolution arithmetic circuit. When the ROM address is "0", the RAM address is also "0". Thus, the RAM address goes a times repetitively through the cycle 0, 1, 2, ..., m-2, m-1, while the ROM address goes from "0" to "N-1". During this time, except when the ROM address is "m-1", the RAM 76 is in the read-mode, since the $\overline{R/W}$ signal is L level. The coefficient data and multiplicand data are therefore supplied to the accumulator 71 from the ROM 72 and RAM 76. The accumulator 71 calculates the output data by performing the convolution algorithm every time the RAM address goes through a complete cycle, just as in the preceding embodiment. When the ROM address is "m-1", the $\overline{R/W}$ signal generated by the R/W signal generating circuit 78 changes to H level, the RAM 76 changes to the write-mode, and the high impedance state of the gate 75 is released, so that the input signal x(d) (d represents a fixed time) is written in the RAM 76 and supplied to the accumulator 71. At this time of d, the RAM 76 contains the multiplicand data stored in the preceding stage The multiplicand data x(d-(m-1)), x(d-(m-2)), x(d-(m-3)), .... x(d) are stored in sequence at the RAM addresses 0, 1, 2, ..., m-1. The ROM 72 holds, in the ROM addresses 0, 1, 2, ..., N-1, the coefficient data g(0) to g(N-1), in accordance with a relationship of regular correspondence, in accordance with the definitions given earlier, with the multiplicand data.

In the process wherein the ROM address in Fig. 8 shifts from "0" to "N-1", a series of convolution calculations (a times) are performed, using these data. Then, when the final ROM address "N-1" is reached, the counter control signal changes to H level. This causes the RAM address to be incremented by +2 with the next clock signal, skipping "0" and starting from "1". Following this, the cycle is therefore repeated, in which the RAM address goes through 1, 2, ..., m-1, 0 a total of a times whilst the ROM address shifts through "0" to " N-1". That is, the RAM addresses corresponding to the ROM addresses are moved up by 1 in each case compared with the series of convolution calculations performed in the preceding stage. When, during this process, the ROM address is "m-1", the new input signal x(d+1) is written in the RAM address "0" so that the oldest data x(d-(m-1)) of the previously stored multiplicand data is replaced by the newest multiplicand data x(d+1). Consequently, the multiplicand data that are multiplied with the coefficient data are respectively shifted to become the next data, x(d+1) being the most recent data. The data x(d-(m-2)), x(d-(m-3)), ..., x(d), x(d+1) are therefore read out repetitively in this order and supplied to the accumulator 71. The accumulator 71 therefore executes a series of convolution calculations in which t in the foregoing definitions is replaced by d+1.

When the above operation is continued, after the series of convolution calculations of the second embodiment is completed, series of convolution calculations are executed one after another, with the input signal providing the most recent multiplicand data, by incrementing the RAM address by +2, and when the next calculation is performed, replacing the oldest mutiplicand data by the newest input data.

As explained above, therefore, in the second embodiment (which is a generalization of the first embodiment), a complicated convolution operation in which the sampling frequency is stepped up by the factor of a can be realized by a simple circuit configuration, and also this convolution arithmetic processing can be performed on the real-time domain. This is achieved by employing a scale-of-$^N/_a$ variable counter to point the RAM addresses in which the multiplicand data is stored, and by using a scale-of-N counter to point the ROM addresses in which the coefficient data are stored, in a regular arrangement. Furthermore, by utilizing the output of the scale-of-N counter to generate and control a counter control signal that controls the scale-of-$^N/_a$ variable counter, or the $\overline{R/W}$ signal that specifies the operating mode of a RAM, the circuit architecture can be made more efective and switching of the various signals can be achieved with accurate timing.

It should be noted that, in the above embodiment, the switching timing of the $\overline{R/W}$ signal is set when the count of the scale-of-N counter is "m-1", and the switching of the counter control signal is set to occur when the count of the scale-of-N counter is "N-1", but the invention is not limited to this. For example, it could be arranged for these signals to commence from when a specified stage is reached in the series of convolution calculations, or for these signals to be determined by the way in which the ROM addresses correspond with the coefficient data, so that the counter control signal goes to H level when the final address is pointed, the series of convolution calculations having been completed, and for the $\overline{R/W}$ signal to go to H level when the address is pointed at which the oldest multiplicand data is stored, in the next calculation after completion of a series of convolution calculations. In other periods, these signals would both be made to L level.

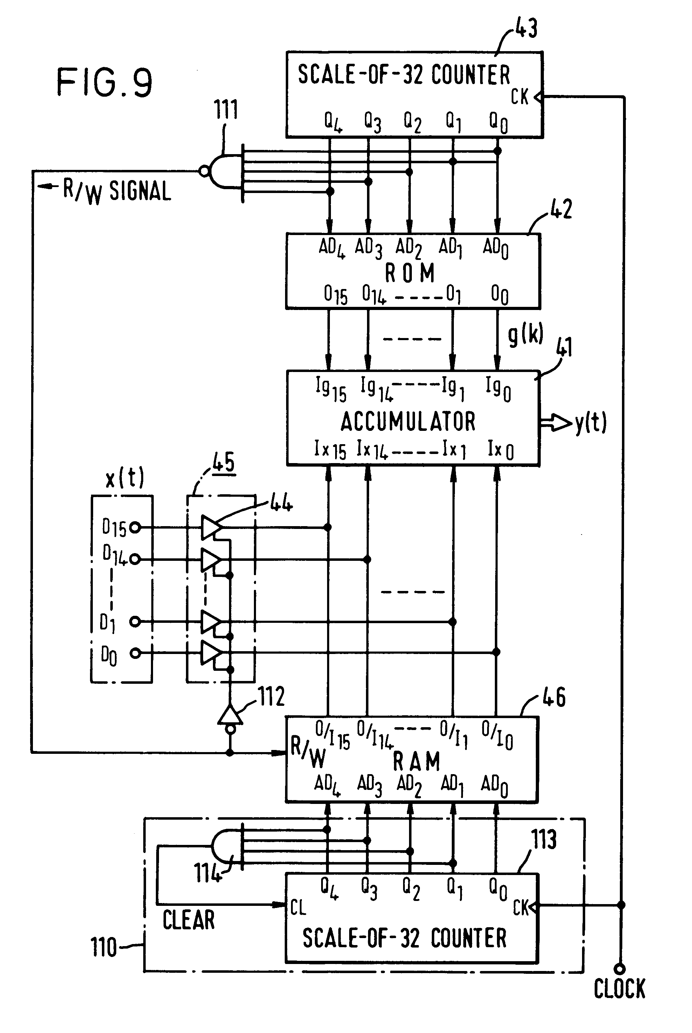

Fig. 9 shows another embodiment (third embodiment) of the convolution arithmetic circuit of this invention. In the following description of the third embodiment, a description of parts which are identical in construction or function to corresponding parts in the foregoing first embodiment will be omitted. Address operation for the ROM 42 that supplies the coefficient data g(k) to the accumulator 41 is performed by a scale-of- 32 counter 43. The ROM 42 stores 16 number of coefficient data. The input signals x(t) that constitiute the multiplicand data are fed to the RAM 46 and the accumulator 41 at the appropriate time through the gate 45 which has arranged in parallel with it a plurality of the tri-state buffers 44. The address operation for the RAM 46 is perforemed by a scale-of-31 counter 110 connected to the address terminals $AD_0$ to $AD_{C-1}$ of the RAM 46. The RAM 46 supplies the multiplicand data which have been stored during the read-mode period of the RAM 46 to the accumulator 41 in response to the address signals outputted from the scale-of-31 counter 110. A 5-inputs NAND gate 111 is connected to output terminals $Q_0$ to $Q_4$ of the scale-of-32 counter 43 and changes a R/W signal as its output to L level when the scale-of-32 counter 43 produces the ROM address "31". . The R/W signal is fed to the tri-state buffers 44 of the gate 45 through an inverter 112 and to the RAM 46, to control the acceptance of the input signal x(t) and the operating mode of the RAM 46. The scale-of-31 counter 110 is comprised of a scale-of-32 counter 113 like the aforementioned counter 43 and a 4-inputs AND gate 114. inputs of the AND gate 114 are connected to the the non-inversed output terminals $Q_1$ to $Q_4$ excluding the output terminal $Q_0$ for the LSB bit data, while the output terminal of the AND gate 114 is connected to the clear terminal CL of the counter 113. The clock signal CLOCK is fed to the clock terminals of both the counters 43 and 113. The output of the AND gate 114 clears the scale-of-32 counter 113 when the non-inversed outputs $Q_1$ to $Q_4$ of the scale-of-32 counter 113 are H level so that the count of the scale-of-32 counter 113 may shifts from "30" to "0", passing the count "31". Thus, the scale-of-31 ounter 110 itself acts like the counter 47 in Fig. 3 or the counter 77 in Fig. 7, in spite of being not connected to the address counter 43 for the ROM 42.

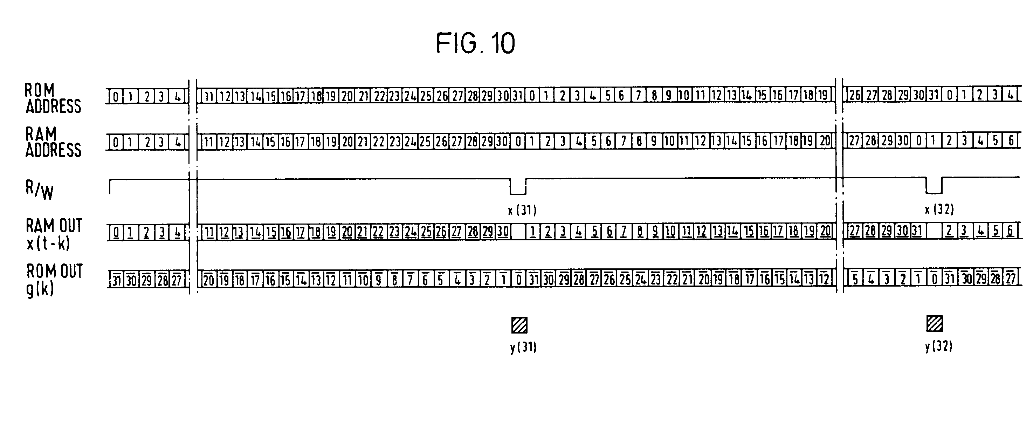

The operation of this embodiment will now be explained with reference to Fig. 9 and Fig. 10. First of all, we shall describe the case where a general convolution algorithm defined by

$$y(t) = \sum_{k=0}^{31} g(k) \cdot x(t-k)$$

is performed during each sampling cycle of the input signal x(t). In this case, the convolution arithmetic circuit of Fig. 9 uses the 5-input NAND gate 111 for generating the R/W signal. The coefficient data g(31), g(30), (29), ...., g(0) are stored, in that order, in the ROM addresses 0, 1, 2, ..., 31 of the ROM 42.

The flow of operations bf this convolution arithmetic circut is shown in Fig. 10. Since the scale number of the scale-of-32 counter 43 that controls the ROM address and the scale-of-32 variable counter 113 that controls the RAM address are equal, every cycle the ROM address shifts from "0" to "31", the RAM address would also pass through a complete cycle. However, after the last RAM address "30" has been counted, i.e., when the ROM address was "30", the output of the 4-input AND gate 114 changes to H level so as to clear the scale-of-32 counter 113 to shift into "0", causing the RAM address to be incremented by +2 with the next clock CLOCK, one cycle later. Also, when the ROM address is "31", the R/W signal also changes to L level and, at this time, the new input signal x(t) is written into the RAM 46. Consequently, when the RAM address is incremented by +2, the RAM outputs (multiplicand data) corresponding to the ROM outputs (coefficient data) are respectively shifted to the next data. This incrementing by +2 causes the last RAM address counted during the cycle to be skipped. When this occurs, the multiplicand data (oldest data) stored at that address is replaced by the latest input signal x(t). If the input signal that is presently applied to the gate 45 is assumed as x(31), the accumulator 41 performs a accumulating of the multiplicand data x(0), x(1), ..., x(30) read out from the RAM 46 with the coefficient data read out from the ROM 42. Its accumulating output is then latched, at the stage where the input signal x(31) is inputted from the gate 45 and where the coefficient data is g(31). If the latched data is called as y(31), we have:

$$y(31) = g(31) \cdot x(1) + g(30) \cdot x(2) + .... + g(1) \cdot x(30) +$$
$$g(0) \cdot x(31).$$
$$= \sum_{k=0}^{31} g(k) \, x(31-k)$$

After the convolution operation for the output data y(31), the next input signal x(32) is applied to the gate 45, and the RAM address is incremented by +2. The multiplicand data read out from the RAM 46 are therefore: x(2), x(4), ..., x(32), and these multiplicand data x(2), x(3), ..., x(32),, together with the coefficient data g(31), g(30), ...., g(0) are supplied, in order, to the accumulator 41. The accumulator 41 therefore calculates y(32), i.e.,

$$y(32) = \sum_{k=0}^{31} g(k) \cdot x(32-k)$$

just as in the preceding step. Subsequently in the same way, the convolution arithmetic circuit calculates the output data y(33), y(34), ...., using the definition

$$y(t) = \sum_{k=0}^{31} g(k) \cdot x(t-k)$$

given previously, using as the most recent multiplicand data x(t) the input signal x(33), x(34), .... every time this is entered.

When the above operation is continued, after the series of convolution calculations of the third embodiment is completed, series of convolution calculations are executed one after another, with the input signal providing the most recent multiplicand data, by incrementing the RAM address by +2, and when the next calculation is performed, replacing the oldest muticplicand data by the newest input data.

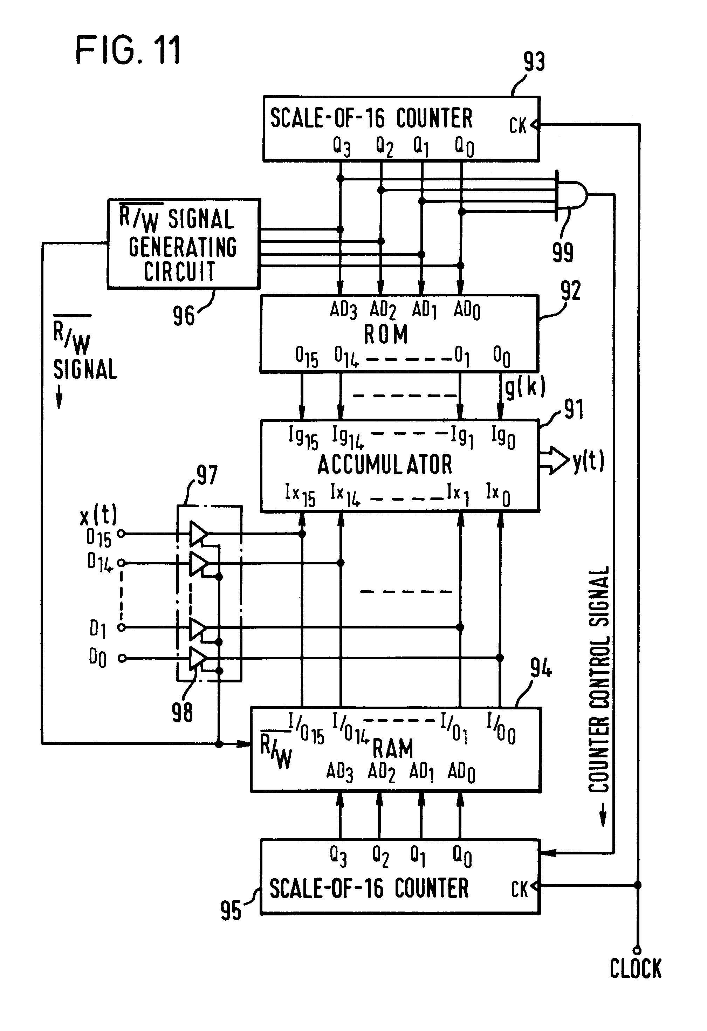

Fig. 11 to Fig. 13 show another embodiment (fourth embodiment) of this invention. The fourth embodiment is one in which the convolution operation is such that either the sampling frequency does not change, or, in contrast to the preceding embodiments, the sampling frequency is reduced in the ratio $^1/_a$. In this embodiment, the sampling number of the coefficient data is set to 16. Consequently, as shown in Fig. 11, in the convolution arithmetic circuit of the fourth embodiment, the address operation for the ROM 92 that supplies the coefficient data g(0) to g(15) to the accumulator 91 is performed by a synchronous scale-of-16 counter 93, and the address operation for the RAM 94 that supplies the multiplicand data is carried out by a scale-of-16 variable counter 95. An $\overline{R/W}$ signal generating circuit 96 is connectd to the output terminals $Q_0$ to $Q_3$ of the four bits of a scale-of-16 counter 93. Thus the $\overline{R/W}$ signal that is thereby generated and controlled specifies the operating mode of the RAM 94 and is applied to the select terminal of each of tri-state buffers 98 of the gate 97, to control the feeding to the RAM 94 and the accumulator 91 of the input signal x(t) that is inputted to the gate 97 from an external device. As in the preceding embodiments, the counter control signal that effects a temporary incrementation (+2) of the output of the scale-of-16 variable counter 95 is generated by a 4-input AND gate 99 connected to the output terminals $Q_0$ to $Q_3$ of the scale-of-16 counter 93. The configuration of the accumulator 91 is practically the same as that of the accumulator 41 of the first embodiment, shown in Fig. 5. However, in the present embodiment, the output of the accumulator 91 is latched when the count of the scale-of-16 counter 93 is "15" and is taken as the output data y(t).

A convolution arithmetic ciruit of the above configuration can realize the various convolution algorithms to be described below by setting to a desired state the $\overline{R/W}$ signal generating circuit 96 and the coefficient data previously stored in the ROM 92, as will be described. First of all, as an example (Example 1), we shall describe the case where a general convolution algorithm defined by

$$y(t) = \sum_{k=0}^{15} g(k) \cdot x(t-k)$$

is performed during each sampling cycle of the input signal x(t). That is, we shall describe the case in which the convolution operation is performed without altering the sampling frequency. In this case, the convolution arithmetic circuit of Fig. 8 uses a 4-input AND gate as the $\overline{R/W}$ signal generating circuit 96. The coefficient data g(15), g(14), g(13), ...., g(0) are stored, in that order, in the ROM addresses 0, 1, 2, ..., 15 of the ROM 92. Acatually, it is possible to use this $\overline{R/W}$ signal generating circuit 96 to also provide the function of the 4-input AND gate 99 that generates the counter control signal.

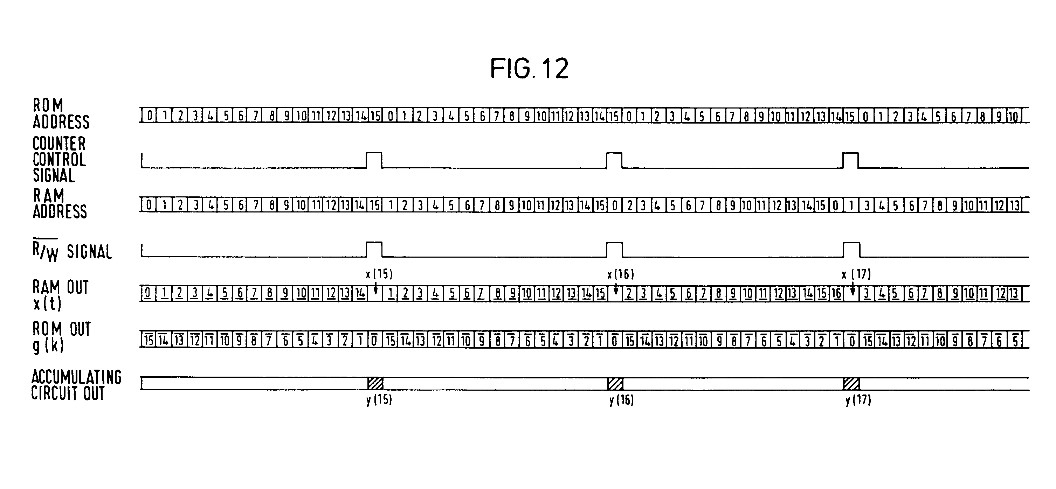

The flow of operations of this convolution arithmetic circut is shown in Fig. 12. Since the scale number of the scale-of-16 counter 93 that controls the ROM address and the scale-of-16 variable counter 95 that controls the RAM address are equal, every cycle the ROM address shifts from "0" to "15", the RAM address also passes through a complete cycle. However, then the last RAM address is counted, i.e., when the ROM address is "15", the counter control signal changes to H level, causing the RAM address to be incremented by +2 with the next clock, one cycle later. Also, when the ROM address is "15", the $\overline{R/W}$ signal also changes to H level and, at this time, the new input signal x(t) is written into the RAM 94. Consequently, when the RAM address is incremented by +2, the RAM outputs (multiplicand data)

12

corresponding to the ROM outputs (coefficient data) are respectively shifted to the next data. This incrementing by +2 causes the last RAM address counted during the cycle to be skipped. When this occurs, the multiplicand data (oldest data) stored at that address is replaced by the latest input signal x(t). If the input signal that is presently applied to the gate 97 is assumed as x(15), the accumulator 91 performs a accumulating of the multiplicand data x(0), x(1), ..., x(14) read out from the RAM 94 with the coefficient data read out from the ROM 92. Its accumulating output is then latched, at the stage where the input signal x(15) is inputted from the gate 97 and where the coefficient data is g(0). If the latched data is called as y(15), we have:

y(15) = g(0)•x(15) + g(0)•x(14) + .... + g(14)•x(1) + g(15)•x(0).

After the convolution operation for the output data y(15), the next input signal x(16) is applied to the gate 97, and the RAM address is incremented by +2. The multiplicand data read out from the RAM 94 are therefore: x(1), x(2), ..., x(15), and these multiplicand data x(1), x(2), ..., x(15), x(16), together with the coefficient data g(15), g(14), ...., g(1), g(0), are supplied, in order, to the accumulator 91. The accumulator 91 therefore calculates y(16), i.e.,

y(16) = g(0)•x(16) + g(1)•x(15) + .... + g(14)•x(2) + g(15)•x(1)

just as in the preceding step. Subsequently in the same way, the convolution arithmetic circuit calculates the output data y(17), y(18), ...., using the definition

$$y(t) = \sum_{k=0}^{15} g(k) \cdot x(t-k)$$

given previously, using as the most recent multiplicand data x(t) the input signal x(17), x(18), .... every time this is entered.

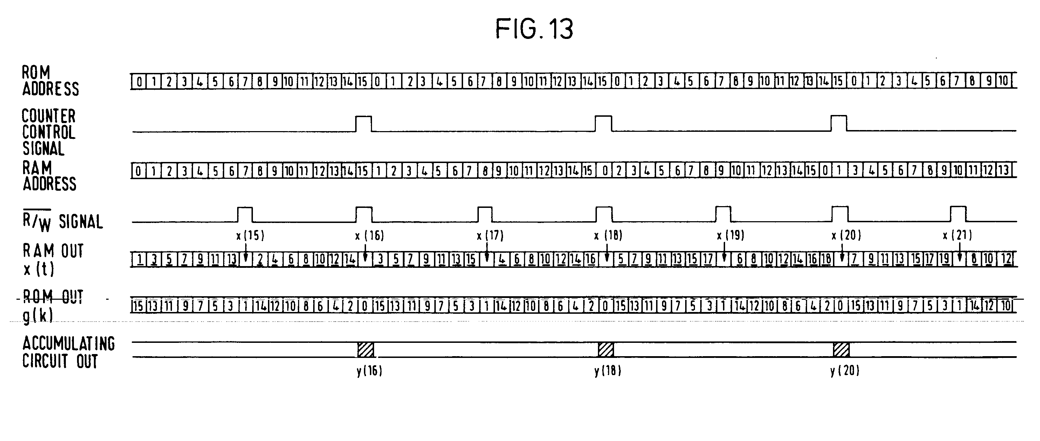

We shall now describe the other operations that the convolution arithmetic circuit shown in Fig. 11 can be made to perform, using the time-chart shown in Fig. 13. Specifically, in this example (Example 2), the sampling frequency is halved, as can be seen from the definition

$$y(2t) = \sum_{k=0}^{15} g(k) \cdot x(2t-k),$$

so that the output data are obtained twice every sampling period of the input signal. The meaning of the convolution algorithm defined by the equation is that the convolution algorithm of Example 1 is performed on alternate input data. In this case, the $\overline{R/W}$ signal generating circuit 96 is provided with a 3-input AND gate circuit which operates on only the least significant 3 bits of the 16-bit counter 93. The AND output of the AND gate circuit provides the $\overline{R/W}$ signal. The $\overline{R/W}$ signal becomes H level when the count of the 16-bit counter 93 is "7" and "15". The coefficient data g(0) to g(15) are stored in the ROM addresses 0, 1, 2, ...., 15 of the ROM 92 in the correspondance relationship

g(15 - 2$\alpha$ ) (when $\alpha$ = 0, 1, ...., 7)
g(14 - 2($\alpha$ - 8)) (when $\alpha$ = 8, 9, ...., 15)

The flow of the operations of such a convolution arithmetic circuit is shown in Fig. 13. Every time the ROM address and RAM address go through one cycle, the $\overline{R/W}$ signal changes to H level twice, at equal intervals (when the ROM address is "7" and "15"), causing, in combination with the sampling period of the input signal suplied from the external device, ($\frac{1}{2}$ of the sampling period in the Example 1), two input signal data to be written in the RAM 94 during each cycle of the RAM address. Also, the RAM address one cycle later is incremented by +2 by the count control signal, and is thereafter counted up one-at-a-time. The two RAM addresses where the new input signals are stored are thus respecitively shifted from the storage addresses used on the previous occasion (e.g., "7" and "15") to the next addresses ("8" and "0"). The input signals that are thus stored with a fixed rule in the RAM 94 provide the multiplicand data that are subsequently read out in sequence when the $\overline{R/W}$ signal is L level, to be fed to the accumulator 91 together with the coefficient data. The input signals that are applied to the gate 97 when the $\overline{R/W}$ signal is H level are directly inputted into the accumulator 91. If we now take the input signal that is applied to the gate 75 as being x(15), as shown in Fig. 13, coefficient data g(15), g(13), ..., g(1) are outputted corresponding to ROM addresses 0, 1, ...., 7, and these coefficient data are fed to the accumulator 91 together with the multiplicand data x(1), x(3), ...., x(15). When subsequently the next input signal x(16) is applied to the gate 97, the multiplicand data x-(2), x(4), ...., x(16) are inputted to the accumulator 91 together with the coefficient data g(14), g(12), ...., g(0) corresponding to the ROM addresses 8, 9, ..., 15. The output of the accumulator 91 obtained as a result of accumulating of these data is latched to provide the output data y(16). Specifically, at this time the accumulator 91 has performed the calculation

$$y(16) = g(15)^{\bullet}x(1) + g(13)^{\bullet}x(3) + .... + g(1)^{\bullet}x(15) + g(14)^{\bullet}x(2) + g(12)^{\bullet}x(4) + .... + g(0)^{\bullet}x(16)$$

It may be pointed out that rearranging the right-hand side of this expression gives:

$$y(16) = g(0)^{\bullet}x(16) + g(1)^{\bullet}x(15) + .... + g(14)^{\bullet}x(2) + g(15)^{\bullet}x(1)$$

which is the same as when the output data y(16) is calculated by the convolution operation of Example 1, in which the samping frequency is unchanged. After thus calculating the output data y(16), the coefficient data are read out from the ROM 92 as in the preceding cycle, and the multiplicand data are read out from the RAM 94, but incremented by 1 in each case relative to the coefficient data. In addition, the new input signals x(17) and x(18) are accepted, so the accumulator 91 now performs the calculation:

$$y(18) = g(15)^{\bullet}x(3) + g(13)^{\bullet}x(5) + .... + g(1)^{\bullet}x(17) + g(14)^{\bullet}x(4) + g(12)^{\bullet}x(6) + .... + g(0)^{\bullet}x(18)$$

The subsequent procedure is the same as that already described, with the convolution arithmetic circuit calculating the output data in accordance with the definition:

$$y(2t) = \sum_{k=0}^{15} g(k) \cdot x(2t-k)$$

given earlier, every time two input signal data are accepted.

As can be seen from the above algorithm, such a convolution calculation, in which the sampling frequency is decreased by $\frac{1}{2}$, is achieved by executing, on alternate input data, a convolution calculation in which the sampling frequency is unchanged. Thus the output data of the intervening omitted calculations represent unnecessary data. Usually, therefore, when the sampling frequency is to be halved, respective output data are calculated, as in the procedure of Example, 1, every time new input signals are accepted, and alternate output data are then extracted.

However, the convolution operation in Example 2 does not execute calculations which would result in unnecessary data but, instead, calculates continuously only the data that are actually required. This eliminates time-wasting and so enables arithmetic processing to be performed to the same number of orders as in Example 1 even on an input signal that is supplied with a period of $\frac{1}{2}$ that of the input signal that was dealt with in Example 1.

In the Examples 1 and 2, convolution arithmetic circuits have been described in Which the sampling frequency is unchanged, and in which it is halved. However, it is possible, based on the method illustrated in the Example 2, to decrease the sampling frequency in the ratio $^1/_a$ by suitable switching of the $\overline{R/W}$ signal and arrangement of the coefficient data in the ROM. In this case also, a convolution arithmetic circuit according to this invention can be made to perform real-time arithmetic processing without needing to have a complex cofiguration.

In the first, second and fourth embodiments which have so far been described, the scale numbers of the counter that points the ROM addresses which the coefficient data are stored, and of the counter that points the RAM addresses, in which the multiplicand data are stored, are set in a prescribed ratio. This makes it possible to design convolution arithmetic circuits of various kinds, depending on the object for which they are to be used, by swithcing the $\overline{R/W}$ signal and the counter control signal with presecribed timing. In the above three embodiments, the means for generatng the $\overline{R/W}$ signal and the counter control signal, or the means for introducing the input signal, are practically identical in construction in all three embodiments. However, present technology provides various different methods which could be used and the invention is not restriced to the method of realization shown in these embodiments. Apart from this, the numerical values of the coefficient data at the required time, or their ouput sequence, can be altered. Furthermore, although in the above embodiments the counter control signal was produced by temporarily incrementing the count of a counter by +2, this could be achieved by another operation, depending on the design of the counter, in accordance with the calculations that are to be mede.

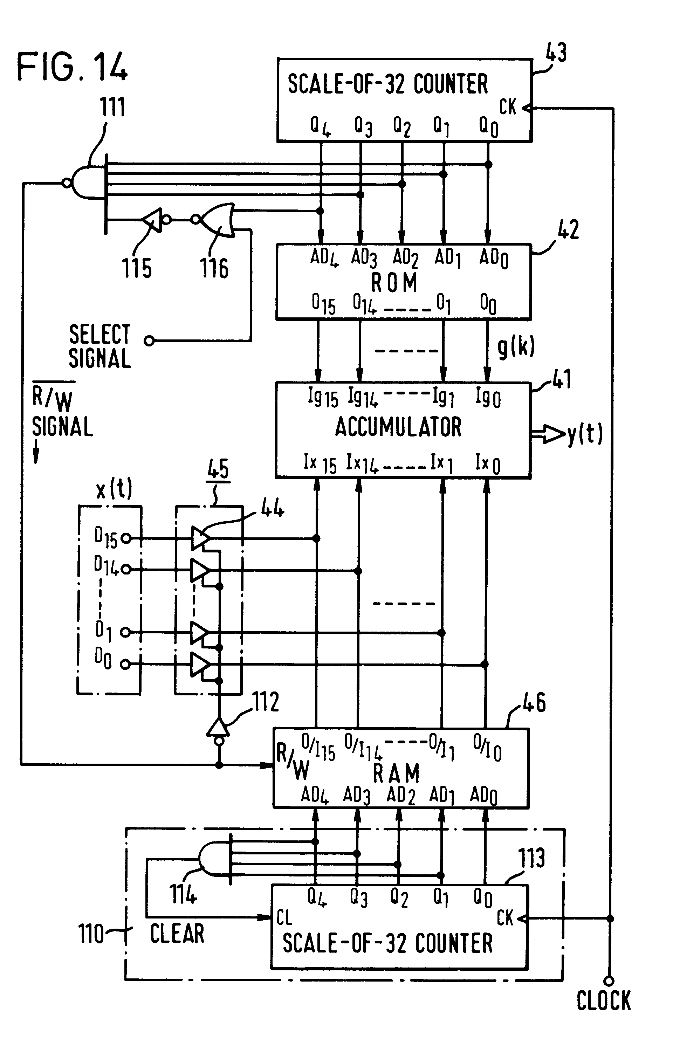

Fig. 14 shows another embodiment (fifth embodiment) of the convolution arithmetic circuit of this invention. In the fifth embodiment, a circuit arrangement is same as that of the third embodiment shown in Fig. 9 except the following. That is, one input of the NAND gate 111 is connected to the non-inversed output terminal Q4, i.e., the MSB bit terminal of the counter 4 through an inverter 115 and a 2-input NOR gate 116. One input of the NOR gate 116 is applied a select signal (to be descrived later). Then, a description of parts which are identical in construction or function to corresponding parts in the foregoing third embodiment will be omitted.

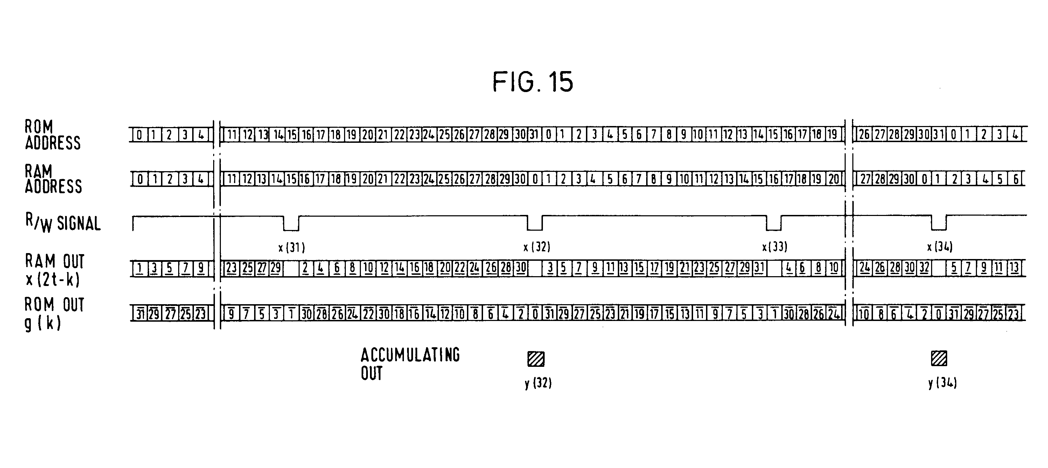

The operation of this embodiment will now be explained with reference to Fig. 14 and Fig. 15. A convolution arithmetic ciruit of the above configuration can realize two kinds of convolution algorithms to be described below by setting to a desired state the select signal which is applied to the one input of the NOR gate 116. If in case that the select signal is set in L level, the circuit becomes equivalent with the circuit configuration of the third embodiment, i.e., the circuit of Fig. 9. As a result, the operation of the case is same as that of the Fig. 9 and will be omitted herefrom.

However, if in case that the select signal is set in H level, the NAND gate 111 operates like a 4-inputs NAND gate whose four inputs are connected to the non-inversed output terminals $Q_0$ to $Q_3$ for the four LSB bit data. Then, the R/W signal from the NAND gate 111 changes twice a cycle of the ROM address. As a result, the sampling frequency is reduced in the ratio $\frac{1}{2}$ so that the convolution arithmetic operation defined by below is procecuted:

$$y(2t) = \sum_{k=0}^{31} g(k) \cdot x(2t-k),$$

so that the output data are obtained twice every sampling period of the input signal. The meaning of the convolution algorithm defined by the equation is that the convolution algorithm is performed on alternate input data. The coefficient data g(k) (k = 0, 1, ..., 31) are stored in the ROM addresses 0, 1, ..., 31 of the ROM 42 in the correspondance relationship

g(31 - 2$\alpha$ ) (when $\alpha$ = 0, 1, ...., 15)
g(30 - 2($\alpha$ - 16)) (when $\alpha$ = 16, 17, ..., 31)

The flow of the operations of such a convolution arithmetic circuit is shown in Fig. 15. Every time the ROM address goes through one cycle, the R/W signal changes to L level twice, at equal intervals (when the ROM address is "15" and "31"), causing, in combination with the sampling period of the input signal supplied from the external device, ($\frac{1}{2}$ of the sampling period), two input signal data to be written in the RAM 46 during each cycle of the RAM address. Also, the RAM address one cycle later is incremented by +2 as explained in the third embodiment. The two RAM addresses where the new input signals are stored are thus respectively shifted from the storage addresses used on the previous occasion (e.g., "15" and "0") to the next addresses ("16" and "1"), caused by the scale number of the counter 110 for the RAM address is less by 1 than the counter 43 for the ROM address. The input signals that are thus stored with a fixed rule in the RAM 46 provide the multiplicand data that are subsequently read out in sequence when the R/W signal is L level, to be fed to the accumulator 41 together with the coefficient data. Thus, the accumulator 41 performs the calculation to produce the output data, e.g., y(32) as expressed below for the every input data, e.g., x(31) and x(32) in every cycle of the counter 43

y(32) = g(31)•x(1) + g(29)•x(3) + .... + g(1)•x(31) + g(30)•x(2) + g(28)•x(4) + .... + g(0)•x(32)

Similarly, the output data y(34) following the y(32) is expressed by:

y(34) = g(31)•x(3) + g(29)•x(5) + .... + g(1)•x(33) + g(30)•x(4) + g(28)•x(6) + .... + g(0)•x(34)

which is the same as when the output data y(16) is calculated by the convolution operation of Example 1, in which the samping frequency is unchanged. After thus calculating the output data y(16), the coefficient data are read out from the ROM 92 as in the preceding cycle, and the multiplicand data are read out from the RAM 94, but incremented by 1 in each case relative to the coefficient data. In addition, the new input signals x(17) and x(18) are accepted, so the accumulator 91 now performs the calculation:

y(18) = g(15)•x(3) + g(13)•x(5) + .... + g(1)•x(17) + g(14)•x(4) + g(12)•x(6) + .... + g(0)•x(18)

The third embodiment is able to progress for changing the sampling frequency to $\frac{1}{4}$, $\frac{1}{8}$, or more by modifying the connection between the NAND gate 111 and the output terminals of the counter 43 for the ROM address.

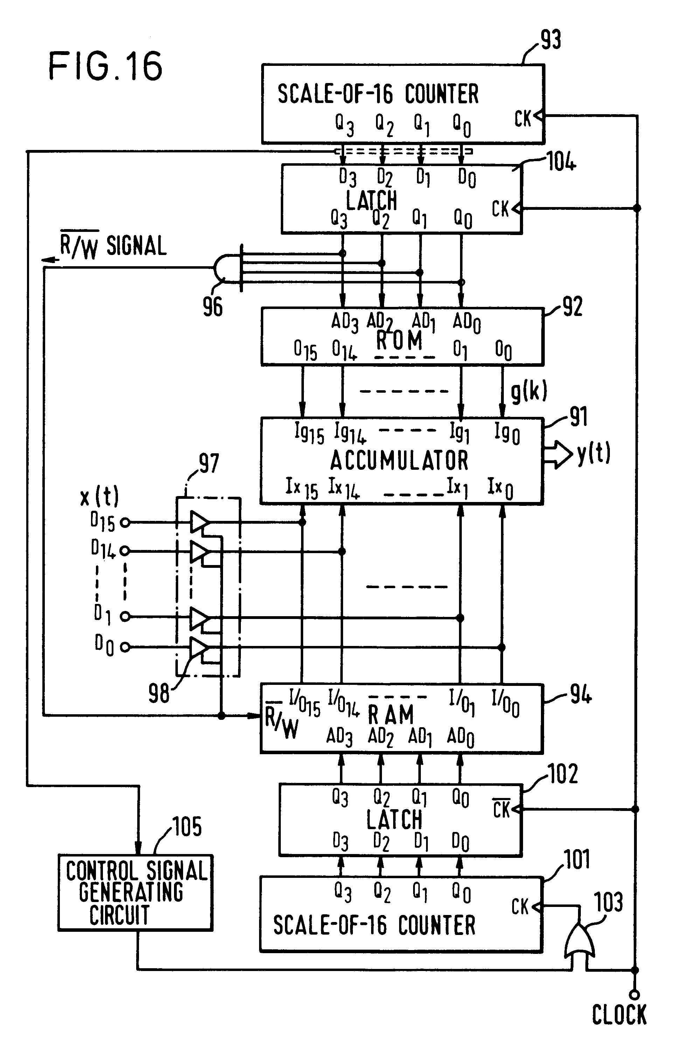

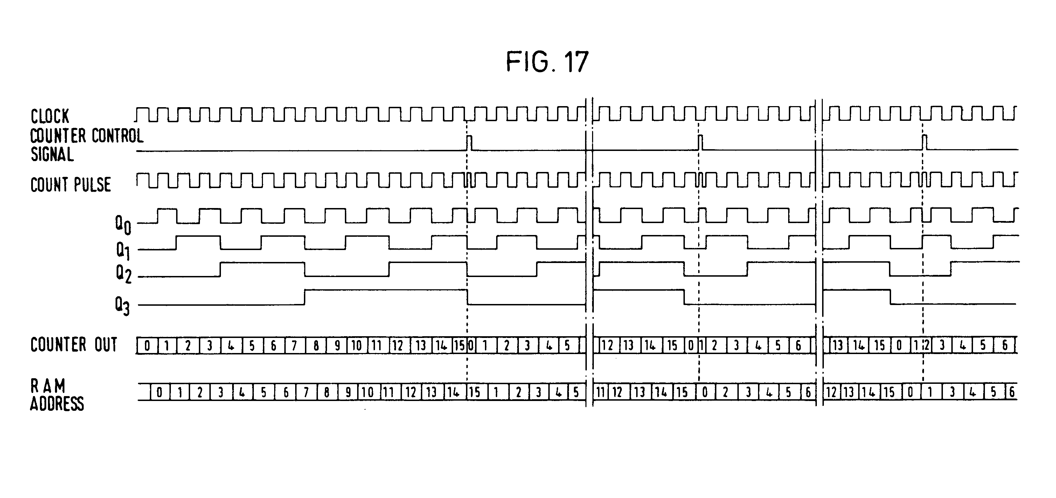

In the next embodiment (sixth embodiment), we describe a case in which the calculation of foregoing Example 1 of the fourth embodiment is achieved by another method. The sixth embodiment is provided of another counting means which points the memory address that stores the multiplicand data, and of the control means that temporarily alters the output of the count means. The circuit layout of the fourth embodiment is shown in Fig. 16. Fig. 17 is a timing chart to explain the operation of Fig. 16. In the following description with reference to the drawings, parts which are the same as corresponding parts in Fig. 11 are given the same reference numerals but a description of them will not be repeated. In the convolution arithmetic circuit of the sixth embodiment, the means that specifies the address of the RAM 94 comprises an ordinary synchronous scale-of-16 counter 101 and a latch circuit 102 that latches the output of the counter 101. The output of the latch circuit 102 is used as the RAM address. The scale-of-16 counter 101 has a two-input OR gate 103 connected to its clock terminal. Thus a count pulse for counting up the scale-of-16 counter 101 consists of a logical sum of the clock signal CLOCK and a counter control signal (to be described later) both connected to the inputs of the two-input OR gate 103. The convolution arithmetic circuit of the fourth embodiment is also provided with a latch circuit 104 between the scale-of-16 counter 93 and the ROM 92 in order to synchronize the ROM address with the RAM address. These two latch circuits 102 and 104 both latch data applied thereto with the fall of the clock signal CLOCK. The abovementioned counter control signal will now be explained. The counter control signal is generated by a control signal generating circuit 105. The control signal generating circuit 105 is so related with the outputs of the scale-of-16 counter 93 that a pulse of width less than the clock signal width is generated when the count of the scale-of-16 counter 93 is "15" during the fall of the clock signal and its next rise, and the pulse is used as a counter control signal. The method whereby such a signal may be generated may be for example extracting a signal pulse at a constant interval (16 times the clock period) from a modified clock signal having a frequency four times the clock signal CLOCK mentioned earlier, and outputting the counter control signal with a timing set by a delay circuit.

The actual operation of the fourth embodiment shown in Fig. 16 will now be explained with reference to Fig. 17. During the period that the counter control signal is L level, the count pulse is identical with the clock signal CLOCK and counts up the scale-of-16 counter 101 on applied to the clock terminal of the counter 101 or its rising edge. The counter output that appears at the output terminals $Q_0$ to $Q_3$ of the scale-of-16 counter 101 therefore shifts sequentially through 0, 1, 2, ...., 15. The counter output is latched at the fall of the clock signal CLOCK by the latch circuit 102 and so is delayed by half the clock period before being used to provide the RAM address. Thus the counter control signal changes to H level when 16 clock pulses of the clock signal CLOCK have been counted, i.e., after the fall of the 16th clock pulse, returning to L level again until the next clock signal rising edge. Two count pulses therfore appear in the pulse period of the clock signal. The counter output of the scale-of-16 counter 101 therefore shifts from "15" to "0" during this time, becoming "1" on the rise of the next clock pulse. Since the latch circuit 102 latches the counter output on the rise of the clock signal, after the counter output "15' is latched, it skips "0" and latches "1". That is, the RAM address shifts from "15" to "1". Subsequent operation is the same as that already described. The counter control signal changes with a fixed period, so the RAM address in incremented by +2 after one cycle, follwoing the same pattern as the RAM address shown in Fig. 12. The ROM address and the $\overline{R/W}$ signal are also developed as shown in Fig. 13, though a description of them will be omitted.

Thus in this embodiment the same arithmetic processing can be achieved as in Example 1 of the fourth embodiment, proving that the means for realizing this invention may be embodied in many different ways.

As is clear from the above description of the first to the sixth embodiments, the convolution arithmetic circuit of this invention dispenses with a microcomputer to control the convolution calculations on the real-time domain. However, in spite of being a hardware construction, it can be applied to various types of convolution calculation, and so has great prectical value. Consequently, since the coeffecent data that define the transfer function can be freely set, this convolution arithmetic circuit can be used, not only in digital filters as described above, but also in various digital signal processing equipment such as echo machines etc. Further, the memory for storing the coefficient data g(k) can be replaced by a RAM from the ROM through the embodiments, for causing the coefficient data g(k) to be easily rewritten in response to the various usuages of the convolution arithmetic circuit. (Effect of the Invention)

As explained above, the convolution arthmetic circuit of this invention achieves effective control of the two sets of data sequences that take part in the convolution calcultaion by the use of a comparatively

EP 0 143 632 B1

simple circuit configuration, and is thereby very well adapted for real-time processing of the convolution operation.

**Claims**

**1.** A convolution arithmetic circuit comprising:

accumulating means (41) for sequentially multiplying and adding multiplicand data and coefficient data constituting respective elements of two digital data sequences;

a first memory (42) for storing, of said two digital data sequences that are supplied to said accumulator, the coefficient data sequence;

a second memory (46) for storing the multiplicand data sequence of said two digital data sequences;

first, scale-of-N, count means (43) for pointing the address from which the coefficient data stored in said first memory (42) are to be sequentially read;

second, scale-of-$^N/_a$, count means (47,113) (where a is a natural number) for pointing the address for reading the stored multiplicand data from said second memory or for writing the multiplicand data, constituted by an input signal, into said second memory;

means for generating a signal (48,111) specifying the operating mode, read or write, of said second memory (46); and

means (45) for introducing the input signal into said second memory (46) and said accumulating means (41) when said second memory is in write mode; characterised in that

the convolution arithmetic circuit also includes means (57,114) coupled to the counter outputs of said first (43) or second (113) count means for receiving a count value of said first or second count means, and for generating a control signal that temporarily alters the output of said second count means (47,113) at a prescribed count value of said first (43) or second (113) count means.

**2.** A convolution arithmetic circuit according to claim 1 wherein the means (48) for generating a signal specifying the operating mode of said second memory (46) is coupled to the output of said first count means (43), for receiving a count value of the count means (43), and is arranged to generate the signal to specify the write mode of said second memory (46) at a prescribed count value of said first count means (43).

**3.** A convolution arithmetic circuit according to claim 1 or 2 wherein said means (57,114) for generating the control signal for altering the output of said second count means (47,113) is formed by a first gating circuit (57,114) connected to binary digit outputs of said first (43) or second (113) count means.

**4.** A convolution arithmetic circuit according to claim 2 or claim 3 appended to claim 2 wherein said operating mode signal generating means (48) is formed by a second gating circuit connected to outputs of said first count means (43), representative of binary count digits of said first count means.

**Revendications**

**1.** Un circuit arithmétique de convolution comprenant :

un moyen d'accumulation (41) pour multiplier et additionner séquentiellement des données multiplicandes et des données de coefficients qui représentent des éléments respectifs de deux séquences de données numériques ;

une première mémoire (42) pour stocker la séquence des données de coefficients, desdites deux séquences de données numériques qui sont fournies audit accumulateur ;

une seconde mémoire (46) pour stocker la séquence des données multiplicandes desdites deux séquences de données numériques ;

un premier moyen de comptage (43) d'échelle de N, pour désigner l'adresse à partir de laquelle les données de coefficient stockées dans ladite première mémoire (42) seront lues séquentiellement ;

un deuxième moyen de comptage (47, 113) d'échelle de $^N/_a$ (dans lequel a est un entier naturel) pour

17

désigner l'adresse à partir de laquelle seront lues les données multiplicandes stockées dans ladite seconde mémoire ou pour écrire les données multiplicandes, constituées par un signal d'entrée, dans ladite seconde mémoire ;

des moyens pour produire un signal (48, 111) spécifiant le mode opératoire, lecture ou écriture, de ladite seconde mémoire (46) ; et

un moyen (45) pour introduire le signal d'entrée dans ladite seconde mémoire (46) et ledit moyen d'accumulation (41) lorsque ladite seconde mémoire est en mode écriture ;

caractérisé en ce que

le circuit arithmétique de convolution comprend également des moyens (57, 114) reliés aux sorties du compteur desdits premier (43) ou second (113) moyens de comptage pour recevoir une valeur de comptage desdits premier ou second moyens de comptage, et pour produire un signal de commande qui modifie temporairement la sortie dudit second moyen de comptage (47, 113) à une valeur de comptage prescrite dudit premier (43) ou second (113) moyen de comptage.

**2.** Un circuit arithmétique de convolution suivant la revendication 1, dans lequel le moyen (48) pour produire un signal spécifiant le mode opératoire de ladite seconde mémoire (46) est relié à la sortie dudit premier moyen de comptage (43) afin de recevoir une valeur de comptage du moyen de comptage (43), et est disposé pour produire le signal pour spécifier le mode écriture de ladite seconde mémoire (46) à une valeur de comptage prescrite dudit premier moyen de comptage (43).

**3.** Un circuit arithmétique de convolution suivant la revendication 1 ou 2, dans lequel ledit moyen (57, 114) pour produire le signal de commande destiné à modifier la sortie dudit second moyen de comptage (47, 113) est constitué par un premier circuit de portes (57, 114) relié aux sorties numériques binaires desdits premier (43) ou second (113) moyens de comptage.

**4.** Un circuit arithmétique de convolution suivant la revendication 2 ou la revendication 3 dépendante de la revendication 2, dans lequel ledit moyen (48) produisant le signal de mode opératoire est constitué par un second circuit de portes relié aux sorties dudit premier moyen de comptage (43), représentatif des chiffres de comptage binaire dudit premier moyen de comptage.

## Patentansprüche

**1.** Schaltung zur arithmetischen Faltung mit
einem Akkumulator (41) zum sequentiellen Multiplizieren und Addieren von Multiplikandendaten und Koeffizientendaten, die jeweils Elemente zweier digitaler Datenreihen darstellen,
einem ersten Speicher (42) zum Speichern der dem Akkumulator zugeführten Koeffizientendatenreihen der beiden digitalen Datenreihen,
einem zweiten Speicher (46) zum Speichern der Multiplikandendatenreihe der beiden Datenreihen,
einem ersten n-fach-Zähler (43) zur Angabe der Adresse, unter der die in dem ersten Speicher (42) gespeicherten Koeffizientendaten sequentiell auszulesen sind,
einem zweiten (N/a)-fach-Zähler (47, 113) (wobei a eine natürliche Zahl ist) zur Angabe der Adresse zum Auslesen der gespeicherten Multiplikandendaten aus dem zweiten Speicher oder zum Einschreiben der von einem Eingangssignal gebildeten Multiplikandendaten in den zweiten Speicher,
Mitteln (48, 111) zum Erzeugen eines Signals, das den Lese- oder Schreib-Modus des zweiten Speichers spezifiziert, und
Mitteln (45) zum Eingeben des Eingangssignals in den Zweiten Speicher (46) und in den Akkumulator (41), wenn der zweite Speicher sich im Schreib-Modus befindet,
**dadurch gekennzeichnet,**
daß die Schaltung zur arithmetischen Faltung ferner mit den Zählerausgängen des ersten (43) oder zweiten (113) Zählers verbundene Mittel (57, 114) aufweist zur Aufnahme eines Zählwerts des ersten oder zweiten Zählers und zur Erzeugung eines Steuersignals, das das Ausgangssignal des zweiten Zählers (47, 113) temporär bei einem vorgeschriebenen Zählwert des ersten (43) oder zweiten (113) Zählers ändert.

**2.** Schaltung zur arithmetischen Faltung nach Anspruch 1, bei der die Mittel (48) zur Erzeugung des den Betriebs-Modus des zweiten Speichers (46) spezifizierenden Signals zur Aufnahme eines Zählwerts des ersten Zählers (43) mit dem Ausgang des ersten Zählers (43) verbunden und so angeordnet sind, daß sie das Signal zur Spezifizierung des Schreib-Modus des zweiten Speichers (46) bei einem vorgeschriebenen Zählwert des ersten Zählers (43) erzeugen.

**3.** Schaltung zur arithmetischen Faltung nach Anspruch 1 oder 2, bei der die Mittel (57, 114) zur Erzeugung des Steuersignals für die Änderung des Ausgangssignals des zweiten Zählers (47, 113) aus einer mit Binärzifferausgängen des ersten (43) oder zweiten (113) Zählers verbundenen ersten Gatterschaltung (57, 114) bestehen.

**4.** Schaltung zur arithmetischen Faltung nach Anspruch 2 oder nach dem von Anspruch 2 abhängigen Anspruch 3, bei der die Mittel (48) zur Erzeugung des den Betriebsmodus spezifizierenden Signals aus einer zweiten Gatterschaltung bestehen, die mit Ausgängen des ersten Zählers (43) verbunden ist, welche binäre Zählziffern des ersten Zählers repräsentieren.

# FIG. 1

## PRIOR ART

11 → LOW-PASS FILTER (12) → SAMPLE-HOLD CIRCUIT (13) → A/D CONVERTER (14) → DIGITAL FILTER (21) → DIGITAL PROCESSING CIRCUIT (15) → RECORDING MEDIUM (16)

RECORDING MEDIUM (16) → DIGITAL DEMODULATION PROCESSING CIRCUIT (17) → DIGITAL FILTER (21) → D/A CONVERTER (18) → LOW-PASS FILTER (19) → 20

EP 0 143 632 B1

# FIG. 2
### PRIOR ART

# FIG. 3
### PRIOR ART

# FIG. 4

# FIG. 5

FIG. 6

FIG. 7

# FIG. 8

ROM ADDRESS: 0 1 2 3 4 | m-5 m-4 m-3 m-2 m-1 m m+1 m+2 m+3 | N-6 N-5 N-4 N-3 N-2 N-1 0 1 2 3 4 | m-5 m-4 m-3 m-2 m-1 m m+1 m+2 m+3 | N-5 N-4 N-3 N-2 N-1 0 1 2 3

COUNTER CONTROL SIGNAL

RAM ADDRESS: 0 1 2 3 4 | m-5 m-4 m-3 m-2 m-1 0 1 2 3 | m-6 m-5 m-4 m-3 m-2 m 1 2 3 4 5 | m-4 m-3 m-2 m-1 0 1 2 3 4 | m-4 m-3 m-2 m-1 0 2 3 4 5

R/W SIGNAL

EP 0 143 632 B1

FIG.9

# FIG. 10

EP 0 143 632 B1

# FIG. 11

# FIG. 12

EP 0 143 632 B1

# FIG.13

ROM ADDRESS

COUNTER CONTROL SIGNAL

RAM ADDRESS

$\overline{R/W}$ SIGNAL

RAM OUT x(t)

ROM OUT g(k)

ACCUMULATING CIRCUIT OUT

x(15)  x(16)  x(17)  x(18)  x(19)  x(20)  x(21)

y(16)  y(18)  y(20)

FIG.14

# FIG. 15

EP 0 143 632 B1

ROM ADDRESS | 0 1 2 3 4 | 11 12 13 14 15 16 17 18 19 20 21 22 23 24 25 26 27 28 29 30 31 0 1 2 3 4 5 6 7 8 9 10 11 12 13 14 15 16 17 18 19 | 26 27 28 29 30 31 0 1 2 3 4

RAM ADDRESS | 0 1 2 3 4 | 11 12 13 14 15 16 17 18 19 20 21 22 23 24 25 26 27 28 29 30 0 1 2 3 4 5 6 7 8 9 10 11 12 13 14 15 16 17 18 19 20 | 27 28 29 30 0 1 2 3 4 5 6

R/W SIGNAL

x(31)　　　　　　x(32)　　　　　x(33)　　　　　x(34)

RAM OUT x(2t-k) | 1 3 5 7 9 | 23 25 27 29 | 2 4 6 8 10 12 14 16 18 20 22 24 26 28 30 | 3 5 7 9 11 13 15 17 19 21 23 25 27 29 31 | 4 6 8 10 | 24 26 28 30 32 | 5 7 9 11 13

ROM OUT g(k) | 31 29 27 25 23 | 9 7 5 3 1 30 28 26 24 22 30 18 16 14 12 10 8 6 4 2 0 31 29 27 25 23 21 19 17 15 13 11 9 7 5 3 1 30 28 26 24 | 10 8 6 4 2 0 31 29 27 25 23

ACCUMULATING OUT

y(32)　　　　　　　　y(34)

# FIG.16

# FIG. 17

EP 0 143 632 B1